(19) **Europäisches Patentamt / European Patent Office / Office européen des brevets**

(11) **EP 4 629 752 A1**

(12) **EUROPEAN PATENT APPLICATION**
published in accordance with Art. 153(4) EPC

(43) Date of publication:
08.10.2025 Bulletin 2025/41

(21) Application number: 23898394.4

(22) Date of filing: 01.12.2023

(51) International Patent Classification (IPC):
*H05K 1/02* $^{(2006.01)}$    *H05K 1/03* $^{(2006.01)}$

(52) Cooperative Patent Classification (CPC):
(C-Sets available)
**C08K 3/22; H05K 1/02; H05K 1/03;**
C08K 2003/2206; C08K 2003/2237; C08K 2201/001
(Cont.)

(86) International application number:
PCT/KR2023/019709

(87) International publication number:
WO 2024/117871 (06.06.2024 Gazette 2024/23)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 01.12.2022 KR 20220165449

(71) Applicant: IUCF-HYU (Industry-University
Cooperation
Foundation Hanyang University)
Seoul 04763 (KR)

(72) Inventors:
• **JUNG, Yei Hwan**
Seoul 04426 (KR)
• **KIM, Sun Hong**
Seoul 05790 (KR)

(74) Representative: **Dr. Gassner & Partner mbB
Wetterkreuz 3
91058 Erlangen (DE)**

(54) **COMPOSITE SUBSTRATE AND METHOD FOR MANUFACTURING SAME**

(57) Provided is a composite substrate having a variable dielectric constant, the composite substrate comprising: a stretchable polymer matrix formed of a stretchable polymer having elasticity; and a dielectric cluster having a predetermined shape, the dielectric cluster being contained in the polymer matrix and formed from a dielectric powder having dielectric properties, wherein when the composite substrate is stretched, the predetermined shape of the dielectric cluster changes and thus the dielectric constant changes.

[Fig. 1]

**(Cont. next page)**

(52) Cooperative Patent Classification (CPC): (Cont.)

C-Sets
**C08K 3/22, C08L 53/025;
C08K 3/22, C08L 83/04**

## Description

[Technical Field]

The present invention relates to a composite substrate and a method for manufacturing the same, and more specifically, to a composite substrate having elasticity and dielectric properties, in which a dielectric constant substantially decreases linearly and rapidly when the composite substrate is stretched in an elongation direction, and a method for manufacturing the same.

[Background Art]

Conventionally, metal materials have been used in a method for manufacturing a dielectric. For example, Korean Unexamined Patent Publication No. 10-2010-0011023 discloses a method for forming a high-k dielectric film, in which a high-k dielectric film formed of a metal oxide is formed by repeating, one or more times, a cycle including a step of introducing a metal precursor into a reaction chamber to form an adsorption layer of the metal precursor on a substrate, a step of purging the metal precursor remaining in the reaction chamber, a step of generating oxygen plasma in a showerhead inside the reaction chamber to react the oxygen plasma with the adsorption layer of the metal precursor, and a step of purging a gas and reaction by-products remaining in the reaction chamber.

Meanwhile, the metal material-based dielectric as described above is required to be stretchable in order to be applied to recent flexible systems. The flexible system herein may mean a system having flexibility, and may include wearable devices, for example.

However, as described above, when the dielectric is based only on the metal material, it is obvious that it is difficult to have elasticity.

Accordingly, conventionally, a dielectric including a material having elasticity, for example, a polymer elastomer, together with the metal material as described above, has been developed. For example, Korean Unexamined Patent Publication No. 10-2017-0017612 discloses a polymer dielectric composition including a conductive filler in a polymer elastomer, in which the conductive filler includes a dispersant represented by the following Chemical Formula 1:

<Chemical Formula 1>          $CX_3(CX_2)n-Y$

(where X is H or F, Y is H, $NH_2$, OH, COOH, or $SiR_1R_2R_3$, n is an integer of 1 to 30, and $R_1$, $R_2$, and $R_3$ are the same as or different from each other, and are H, F, Cl, Br, an alkyl group having 1 to 10 carbon atoms, an alkoxy group having 1 to 10 carbon atoms, an alkenyl group having 1 to 10 carbon atoms, an alkyne group having 1 to 10 carbon atoms, an aryl group having 1 to 30 carbon atoms, a cycloalkyl group having 1 to 30 carbon atoms, or a cycloalkenyl group having 1 to 30 carbon atoms).

However, when the existing stretchable dielectric material is stretched, the dielectric constant may change irregularly.

Since the existing stretchable dielectric is irregularly changed in dielectric constant as described above, it may be difficult to apply the conventional stretchable dielectric to flexible systems as a substrate.

This may be because the frequency needs to be maintained within a predetermined range in a high-frequency device of the flexible systems, for example, an antenna, a capacitor, an inductor, a circuit, and the like.

However, as described above, since the dielectric constant is irregularly changed when the existing stretchable dielectric is stretched, the frequency in the high-frequency device may not be maintained within a predetermined range and may be changed.

Therefore, when the stretchable dielectric is stretched, there is a need for a substrate having dielectric constant that is substantially and linearly variable.

[Disclosure]

[Technical Problem]

The technical problem to be solved by the present invention is to provide a composite substrate in which a dielectric constant substantially decreases linearly and rapidly when the composite substrate is stretched in an elongation direction, and a method for manufacturing the same.

Another technical problem to be solved by the present invention is to provide a composite substrate having an excellent thermal conductivity and a method for manufacturing the same.

Still another technical problem to be solved by the present invention is to provide a composite substrate that may be applied to a high-frequency device of a flexible system, and a method for manufacturing the same.

The technical problems to be solved by the present invention are not limited to those described above.

[Technical Solution]

To solve the technical problems, the present invention provides a composite substrate.

According to one embodiment, the composite substrate may include: a stretchable polymer matrix formed of a stretchable polymer having elasticity; and a dielectric cluster having a predetermined shape, included in the polymer matrix, and formed of dielectric powder having dielectric properties, in which when the composite substrate is stretched, the predetermined shape of the dielectric cluster may change so that a dielectric constant of the composite substrate may be varied.

According to one embodiment, when stretching proceeds in an elongation direction, the predetermined shape of the dielectric cluster may be changed such that a number of the dielectric powder per unit volume of the stretchable polymer matrix may decrease, and the dielectric constant may decrease linearly.

According to one embodiment, the composite substrate may have a variable dielectric constant range in a stretch range of 0.1% to 30%, and the variable dielectric range may be 1.5 to 7.5.

According to one embodiment, the dielectric constant may decrease with a gradient in a range of 0.03 to 0.08 in the stretch range of 0.1% to 30%.

According to one embodiment, the composite substrate may have a thermal conductivity in a range of 0.1 W/mk to 10 W/mk.

According to one embodiment, the stretchable polymer may be a silicon-based material, and the silicon-based material may include at least one selected from materials including ecoflex, polydimethylsiloxane (PDMS), and styrene-ethylenebutylene-styrene (SEBS).

According to one embodiment, the dielectric powder may be a metal oxide-based material, and the metal oxide-based material may be at least one selected from metal oxide-based materials including barium titanate, strontium titanate, and aluminum oxide.

To solve the technical problems, the present invention provides a method for manufacturing a composite substrate.

According to one embodiment, the method for manufacturing a composite substrate may include: dispersing a stretchable polymer having elasticity in a solvent to prepare a source solution; mixing dielectric powder having dielectric properties with the source solution to prepare a dielectric source; providing the dielectric source with a catalyst that causes an attractive force between dielectric powders so as to form a dielectric cluster having a predetermined shape from the dielectric powders; and curing the dielectric source in which the dielectric cluster is formed to manufacture the composite substrate having the dielectric cluster that is dispersed in a stretchable polymer matrix formed of the stretchable polymer.

According to one embodiment, in the forming of the dielectric cluster, the catalyst may be provided to the dielectric source by a dripping method, and the catalyst may be water.

According to one embodiment, in the preparing of the source solution, the solvent may be a polar liquid that is non-miscible with water, the polar liquid may include dichloromethane, the stretchable polymer may be a silicon-based material, and the silicon-based material may include at least one selected from a material including ecoflex, polydimethylsiloxane (PDMS), and styrene-ethylene-butylene-styrene (SEBS).

To solve the technical problems, the present invention provides a composite substrate.

According to one embodiment, the composite substrate may include: a stretchable polymer matrix formed of a stretchable polymer having elasticity; and a dielectric cluster having a predetermined shape, included in the polymer matrix, and formed of dielectric powder having dielectric properties, in which when the composite substrate is stretched, the predetermined shape of the dielectric cluster may change so that a dielectric constant of the composite substrate may be varied, the composite substrate may have a variable dielectric constant range in a stretch range of 0.1% to 30%, the variable dielectric constant may be in a range of 1.5 to 7.5, and the dielectric constant may decrease with a gradient in a range of 0.03 to 0.08 in the stretch range of 0.1% to 30%.

[Advantageous Effects]

According to the embodiment of the present invention, it is possible to provide a composite substrate which includes: a stretchable polymer matrix formed of a stretchable polymer having elasticity; and a dielectric cluster having a predetermined shape, included in the polymer matrix, and formed of dielectric powder having dielectric properties, in which when the composite substrate is stretched, the predetermined shape of the dielectric cluster may be changed so that a dielectric constant of the composite substrate may be varied.

More specifically, when the stretching proceeds in an elongation direction, the predetermined shape of the dielectric cluster may be changed such that the number of the dielectric powders per unit volume of the stretchable polymer matrix may decrease, and the dielectric constant may decrease linearly.

Accordingly, the dielectric constant may substantially decrease linearly and rapidly when the stretching proceeds in an elongation direction.

Accordingly, according to the present invention, when the composite substrate is applied to a high-frequency device of a flexible system, frequency characteristics thereof may be excellent.

Meanwhile, according to the embodiment of the present invention, since the composite substrate includes the dielectric powder, a thermal conductivity thereof may be excellent.

Accordingly, according to the present invention, when the composite substrate is applied to a high-frequency device of a flexible system, thermal conductivity characteristics thereof may be excellent.

[Description of Drawings]

FIG. 1 is a view for explaining a composite substrate according to an embodiment of the present invention.

FIGS. 2 to 7 are views for explaining a method for manufacturing a composite substrate according to the embodiment of the present invention.

FIGS. 8 to 54 are views for explaining experimental examples of the present invention.

[Mode for Invention]

Hereinafter, preferred embodiments of the present invention will be described in detail with reference to the accompanying drawings. However, the present invention may be embodied in different forms and should not be construed as limited to the embodiments set forth herein. Rather, the embodiments introduced herein are provided so that the disclosed contents may be thorough and complete and the spirit of the present invention may be sufficiently conveyed to those skilled in the art.

In the present specification, it will be understood that when an element is referred to as being "on" another element, it can be formed directly on the other element or intervening elements may be present. In the drawings, the shapes and the thicknesses of regions are exaggerated for clarity.

In addition, it will be also understood that although the terms first, second, third, etc. may be used herein to describe various elements, these elements should not be limited by these terms. These terms are only used to distinguish one element from another element. Thus, a first element in some embodiments may be termed a second element in other embodiments without departing from the teachings of the present invention. Embodiments explained and illustrated herein include their complementary counterparts. As used herein, the term "and/or" includes any and all combinations of one or more of the associated listed elements.

The singular expression also includes the plural meaning as long as it does not differently mean in the context. In addition, the terms "comprise", "have" etc., of the description are used to indicate that there are features, numbers, steps, elements, or combination thereof, and they should not exclude the possibilities of combination or addition of one or more features, numbers, operations, elements, or a combination thereof. Furthermore, it will be understood that when an element is referred to as being "connected" or "coupled" to another element, it may be directly connected or coupled to the other element or intervening elements may be present.

In addition, the terms " ... unit," " ... or/er," "module", and the like used herein indicate a unit for processing at least one function or operation, which may be implemented by hardware, software, or a combination thereof.

In addition, when detailed descriptions of related known functions or constitutions are considered to unnecessarily cloud the gist of the present invention in describing the present invention below, the detailed descriptions will not be included.

Conventionally, metal materials have been used in a method for manufacturing a dielectric.

Meanwhile, the metal material-based dielectric as described above is required to be stretchable in order to be applied to recent flexible systems. The flexible system herein may mean a system having flexibility, and may include wearable devices, for example.

However, as described above, when the dielectric is based only on the metal material, it is obvious that it is difficult to have elasticity.

Accordingly, conventionally, a dielectric including a material having elasticity, for example, a polymer elastomer, together with the metal material as described above, has been developed.

However, when the existing stretchable dielectric material is stretched, the dielectric constant may change irregularly.

Since the existing stretchable dielectric is irregularly changed in dielectric constant as described above, it may be difficult to apply the conventional stretchable dielectric to flexible systems as a substrate.

This may be because the frequency needs to be maintained within a predetermined range in a high-frequency device of the flexible systems, for example, an antenna, a capacitor, an inductor, a circuit, and the like.

However, as described above, since the dielectric constant is irregularly changed when the existing stretchable dielectric is stretched, the frequency in the high-frequency device may not be maintained within a predetermined range and may be changed.

Accordingly, the present invention provides a composite substrate having dielectric constant that varies substantially and linearly when the composite substrate is stretched.

Hereinafter, a composite substrate according to an embodiment of the present invention will be described with reference to the drawings.

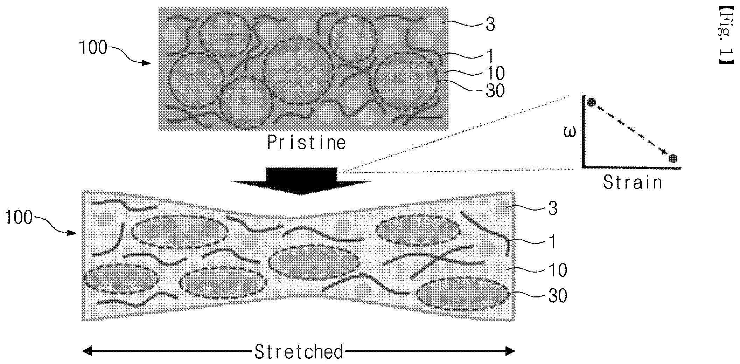

FIG. 1 is a view for explaining a composite substrate according to an embodiment of the present invention.

Referring to FIG. 1, a composite substrate 100 may include at least one of a stretchable polymer 1, a stretchable polymer matrix 10, dielectric powder 3, and a dielectric cluster 30.

Hereinafter, the respective components will be described.

**Stretchable Polymer 1**

According to the embodiment of the present invention, the stretchable polymer 1 may form the stretchable polymer matrix 10 to be described later.

To this end, the stretchable polymer 1 may be a material having elasticity.

According to one embodiment, the stretchable polymer 1 may include a silicon-based material. For example, the silicon-based material may include ecoflex. However, the stretchable polymer 1 is not limited to the above-described ecoflex, and is not limited as long as the stretchable polymer 1 is a silicon-based material as described above. For example, the silicon-based material may be polydimethylsiloxane (PDMS) or styrene-ethylene-butylene-styrene (SEBS).

Accordingly, according to the present invention, the stretchable polymer matrix 10 to be described later may have elasticity because the stretchable polymer matrix 10 includes the stretchable polymer 1, that is, a silicon-based material.

**Stretchable Polymer Matrix 10**

According to the embodiment of the present invention, the stretchable polymer matrix 10 may impart elasticity to the composite substrate 100.

To this end, the stretchable polymer matrix 10 may be formed of the stretchable polymer 1.

Accordingly, as described above, the stretchable polymer matrix 10 may have elasticity.

Meanwhile, referring to FIG. 1, the stretchable polymer matrix 10 may include at least one of the dielectric powder 3 to be described later and the dielectric cluster 30 formed from the dielectric powder 3. The dielectric powder 3 will be described in more detail.

**Dielectric Powder 3**

According to the embodiment of the present invention, the dielectric powder 3 may impart dielectric properties to the composite substrate 100.

To this end, the dielectric powder 3 may be a material having dielectric properties.

According to one embodiment, the dielectric powder 3 may include a metal oxide-based material. For example, the metal oxide-based material may be at least one selected from metal oxide-based materials including barium titanate, strontium titanate, and aluminum oxide. However, the dielectric powder 3 is not limited to the barium titanate, the strontium titanate, and the aluminum oxide described above, and is not limited as long as the dielectric powder 3 is a metal oxide-based material as described above.

Accordingly, according to the present invention, the dielectric cluster 30 to be described later may have dielectric properties because the dielectric cluster 30 includes the dielectric powder 3, that is, a metal oxide-based material.

**Dielectric Cluster 30**

According to the embodiment of the present invention, the dielectric cluster 30 may vary a dielectric constant $\varepsilon$ (see the graph of FIG. 1) of the composite substrate 100.

To this end, the dielectric cluster 30 may be formed of the dielectric powder 3 and have a predetermined shape as shown in FIG. 1. The predetermined shape herein is not limited as long as dielectric powders 3 are formed adjacent to each other. For example, the predetermined shape herein may include a circle, a polygon, and the like formed by the dielectric powders 3 adjacent to each other.

As shown in FIG. 1, when the composite substrate is stretched, the dielectric cluster 30 may vary the dielectric constant $\varepsilon$ by changing the predetermined shape.

This may be because the dielectric cluster 30 is included in the stretchable polymer matrix 10 as described above.

More specifically, as shown in FIG. 1, when the stretching proceeds in an elongation direction (stretched), the predetermined shape of the dielectric cluster 30 may be changed such that the number of dielectric powders 3 per unit volume of the stretchable polymer matrix 10 decreases.

Accordingly, as shown in the graph of FIG. 1, when the stretching proceeds in an elongation direction (stretched), the dielectric constant ε may substantially decrease linearly and rapidly.

That is, when the composite substrate 100 according to the embodiment of the present invention is stretched as shown in FIG. 1, the predetermined shape of the dielectric cluster 30 is changed so that the dielectric constant ε may be varied.

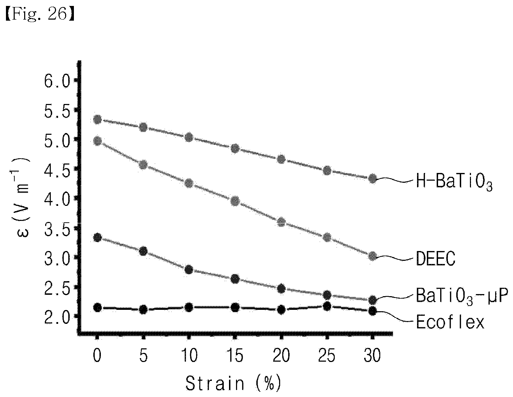

More specifically, according to an experimental example of the present invention, the composite substrate 100 may have a variable dielectric constant ε (see DEEC on y-axis of FIG. 26) in a stretch range (strain, see DEEC on x-axis of FIG. 26) of 0.1% to 30%. In this case, referring to FIG. 26, a range of the variable dielectric constant ε may be 1.5 to 7.5 (see DEEC on y-axis of FIG. 26). The dielectric constant ε herein may mean a relative dielectric constant.

Meanwhile, referring to FIG. 26, the dielectric constant ε (x-axis of FIG. 26) of the composite substrate 100 or DEEC may rapidly decrease with a gradient in a range of 0.03 to 0.08 in a stretch range (strain on y-axis of FIG. 26) of 0.1% to 30%.

Accordingly, according to the present invention, when the composite substrate 100 is applied to a high-frequency device, the composite substrate 100 may have excellent frequency characteristics.

More specifically, in the high-frequency device of the flexible system as described above, for example, an antenna, a capacitor, an inductor, a circuit, and the like, a frequency needs to be maintained within a predetermined range, and in this case, the frequency may follow the following Equation 1:

<Equation 1>

$$fr = \frac{c}{2L_1\sqrt{\varepsilon_r}}$$

(where $f_r$ is a frequency, c is a speed of light, $L_1$ is a stretched length, and $\varepsilon_r$ is a dielectric constant).

According to <Equation 1>, when the high-frequency device is stretched, for example, when the high-frequency device is stretched in an elongation direction, the dielectric constant needs to be decreased in order to maintain the frequency constant.

More specifically, according to <Equation 1>, when the high-frequency device is stretched in an elongation direction as described above, the dielectric constant needs to be decreased by the square of the stretched length.

Therefore, in order to maintain the frequency constant, the high-frequency device may require a gradient in which the dielectric constant rapidly decreases by the square with respect to the stretched length.

Meanwhile, according to the present invention, as described above, the dielectric constant ε (see x-axis of FIG. 26) of the composite substrate 100 or DEEC may rapidly decrease with a gradient in a range of 0.03 to 0.08 in a stretch range (see strain on y-axis of FIG. 26) of 0.1% to 30%.

Accordingly, according to the present invention, when the composite substrate 100 is applied to the high-frequency device, the frequency may be maintained constant, so that the composite substrate 100 may have excellent frequency characteristics. The experimental example of the present invention will be described in more detail.

Meanwhile, according to the embodiment of the present invention, the composite substrate 100 may have an excellent thermal conductivity.

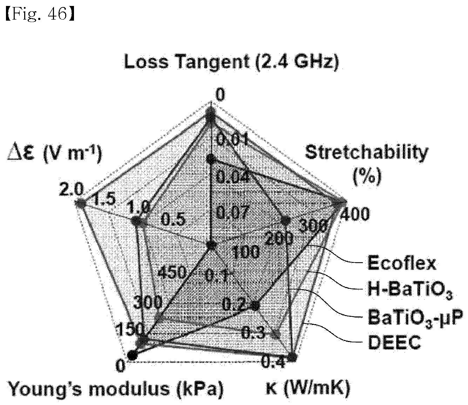

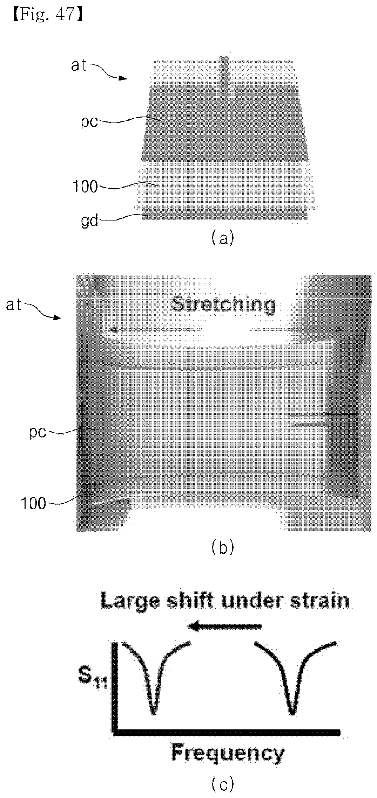

More specifically, according to the experimental example of the present invention, as shown in FIGS. 46 and 47, the composite substrate 100 or DEEC may have a thermal conductivity in a range of 0.1 W/mk to 10 W/mk.

This may be because, according to the present invention, the composite substrate 100 includes the dielectric powder 3 as described above.

Accordingly, according to the present invention, as described above, when the composite substrate 100 is applied to the high-frequency device, the composite substrate 100 may have excellent thermal conductivity characteristics. The experimental example of the present invention will be described in more detail.

Hereinabove, the composite substrate 100 according to the embodiment of the present invention has been described.

Hereinafter, a method for manufacturing the composite substrate 100 according to the embodiment of the present invention will be described with reference to the drawings.

Hereinafter, in the method for manufacturing the composite substrate 100 to be described, descriptions overlapping with the descriptions of the above-described embodiment may be omitted. However, the fact that the overlapping descriptions are omitted below does not mean that the overlapping descriptions are excluded, and the overlapping descriptions refer to the descriptions of the previous embodiment.

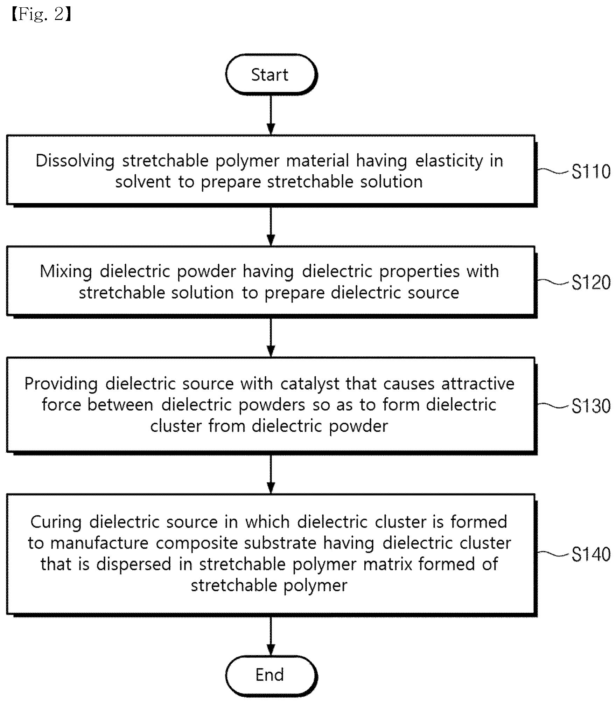

FIGS. 2 to 7 are views for explaining a method for manufacturing a composite substrate according to the embodiment of the present invention.

Referring to FIG. 2, the method for manufacturing the composite substrate 100 may include any one of a step S110 of dispersing thee stretchable polymer 1 having elasticity in a solvent to prepare a source solution, a step S120 of mixing the dielectric powder 3 having dielectric properties with the source solution to prepare a dielectric source, a step S130 of providing the dielectric source with a catalyst that causes an attractive force between dielectric powders 3 so as to form the dielectric cluster 30 having a predetermined shape from the dielectric powders 3, and a step S140 of curing the dielectric source in which the dielectric cluster is formed to manufacture the composite substrate 100 having the dielectric cluster 30 that is dispersed in the stretchable polymer matrix 10 formed of the stretchable polymer 1.

Hereinafter, each step will be described.

### Step S110

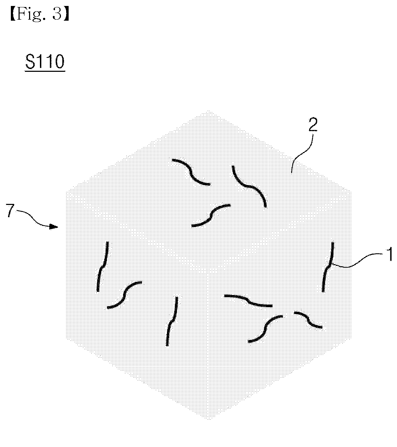

Referring to FIG. 3, in step S110, the stretchable polymer 1 having elasticity may be dispersed in a solvent 2 to prepare a source solution 7.

More specifically, in this step, the stretchable polymer 1 may be prepared by mixing a main agent and a curing agent at the same mass ratio, for example, a mass ratio of 1:1.

Meanwhile, in this step, the prepared stretchable polymer 1 may be dispersed in the solvent 2.

According to one embodiment, in this step, the solvent 2 may be a polar liquid that is non-miscible with water. For example, the polar liquid may include dichloromethane. However, the solvent 2 is not limited to the above-described dichloromethane, and is not limited as long as the solvent 2 is a polar liquid that is non-miscible with water as described above.

Meanwhile, in this step, the stretchable polymer 1 may be a silicon-based material as described above. In this regard, since the descriptions overlap with the descriptions of the previous embodiment, the overlapping descriptions will refer to the descriptions of the previous embodiment.

### Step S120

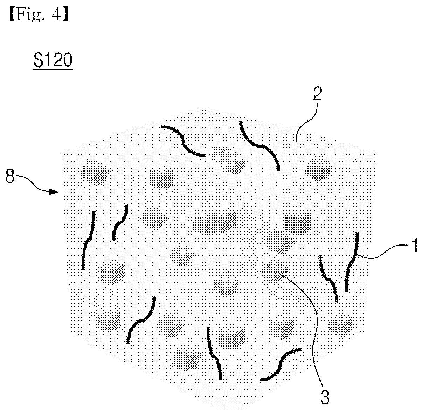

Referring to FIG. 4, in step S120, the dielectric powder 3 having dielectric properties may be mixed with the source solution 7 (see FIG. 3) to prepare a dielectric source 8.

More specifically, in this step, the dielectric powder 3 may have a nanoparticle size. For example, the dielectric powder 3 may have a size of 100 nm.

According to one embodiment, in this step, the dielectric powder 3 may be a metal oxide-based material. In this regard, since the descriptions overlap with the descriptions of the previous embodiment, the overlapping descriptions will refer to the descriptions of the previous embodiment.

### Step S130

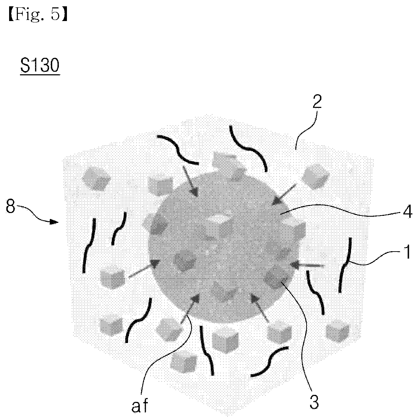

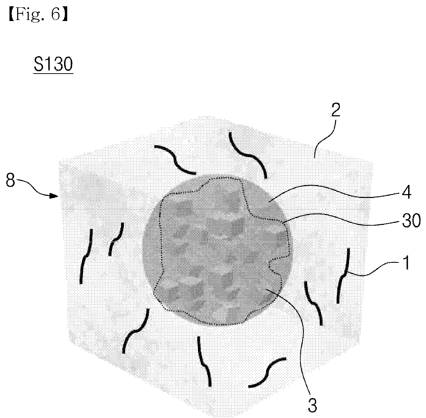

Referring to FIGS. 5 and 6, in step S130, the dielectric source 8 may be provided with a catalyst 4 that causes an attractive force af between dielectric powders 3, so that the dielectric cluster 30 having a predetermined shape may be formed from the dielectric powders 3.

More specifically, in this step, the catalyst 4 may be provided to the dielectric source 8 by a dripping method. The dripping method herein may be understood as a concept that includes dripping the catalyst 4 to the dielectric source 8 and providing the catalyst 4 as liquid droplets.

Accordingly, as shown in FIG. 5, when the catalyst 4 is provided to the dielectric source 8 as the liquid droplets, the attractive force af may be generated between dielectric powders 3, and as shown in FIG. 6, the dielectric cluster 30 having a predetermined shape may be formed of the dielectric powders 3. The predetermined shape herein is not limited as long as the dielectric powders 3 are formed adjacent to each other. In this regard, since the descriptions overlap with the descriptions of the previous embodiment, the overlapping descriptions will refer to the descriptions of the previous embodiment.

Meanwhile, in this step, the catalyst 4 may be provided by the dripping method in a situation where the dielectric source 8 is stirred at a predetermined speed for a predetermined time. For example, in this step, the catalyst 4 may be provided by the dripping method in a situation where the dielectric source 8 is stirred at a speed of 900 rpm to 1100 rpm for 20 minutes.

Accordingly, according to the present invention, it may be easy to form the dielectric cluster 30 having the predetermined shape.

According to one embodiment, the catalyst 4 may be water in this step.

**Step S140**

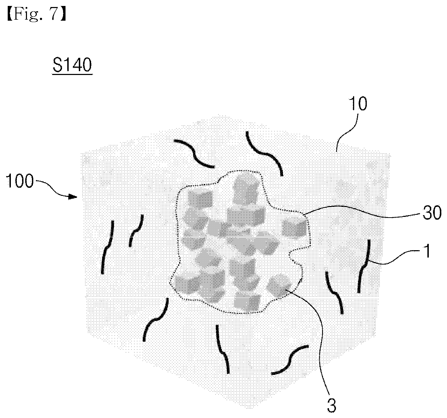

Referring to FIG. 7, in step S140, the dielectric source 8 (see FIG. 6) in which the dielectric cluster 30 is formed may be cured to manufacture the composite substrate 100.

Accordingly, in this step, the composite substrate 100 may have a structure in which the dielectric cluster 30 is dispersed in the stretchable polymer matrix 10 formed from the stretchable polymer 1, as shown in FIG. 7.

Therefore, according to the present invention, as described above, when the composite substrate 100 is stretched (see FIG. 1), the predetermined shape of the dielectric cluster 30 is changed so that the dielectric constant $\varepsilon$ may be varied.

More specifically, according to the experimental example of the present invention, as described above with reference to FIG. 26, the dielectric constant $\varepsilon$ (x-axis of FIG. 26) of the composite substrate 100 or DEEC may rapidly decrease with a gradient in a range of 0.03 to 0.08 in a stretch range (strain on y-axis of FIG. 26) of 0.1% to 30%.

Accordingly, according to the present invention, when the composite substrate 100 is applied to a high-frequency device, the composite substrate 100 may have excellent frequency characteristics. This may be based on <Equation 1> as described above.

According to <Equation 1>, as described above, in order to maintain the frequency constant, the high-frequency device may require a gradient in which the dielectric constant rapidly decreases by the square with respect to the stretched length.

Meanwhile, according to the present invention, as described above, the dielectric constant $\varepsilon$ (see x-axis of FIG. 26) of the composite substrate 100 or DEEC may rapidly decrease with a gradient in a range of 0.03 to 0.08 in a stretch range (see strain on y-axis of FIG. 26) of 0.1% to 30%.

Accordingly, according to the present invention, when the composite substrate 100 is applied to the high-frequency device, the frequency may be maintained constant, so that the composite substrate 100 may have excellent frequency characteristics. In this regard, since the descriptions overlap with the descriptions of the previous embodiment, the overlapping descriptions will refer to the descriptions of the previous embodiment.

Meanwhile, according to the embodiment of the present invention, the composite substrate 100 may also have excellent thermal conductivity as described above. This will be described in more detail in the experimental example of the present invention.

Hereinabove, the method for manufacturing the composite substrate 100 according to the embodiment of the present invention has been described.

Hereinafter, the experimental example of the present invention will be described.

<Manufacture of First Composite Substrates 100, DEEC, DEEC-BaTiO$_3$, And M-BaTiO$_3$ According to Experimental Example of Present Invention>

A main agent and a curing agent were mixed in a mass ratio of 1:1 to prepare ecoflex as the stretchable polymer 1.

12 ml of dichloromethane was prepared as the solvent 2, and 10 g of the ecoflex was dispersed in the dichloromethane to prepare the source solution 7.

6 g of barium titanate (BaTiO$_3$) powder having a size of 100 nm, which served as the dielectric powder 3, was mixed with the source solution 7 to prepare the dielectric source 8.

While stirring the dielectric source 8 at a speed of 1000 rpm for 20 minutes, 1 mL of water serving as the catalyst 4 was provided to the dielectric source 8 as liquid droplets through a dripping method so as to form the dielectric cluster 30 having a circular shape.

The dielectric source 8 in which the dielectric cluster 30 was formed was provided to a mold and cured to manufacture first composite substrates 100, DEEC, DEEC-BaTiO$_3$, and M-BaTiO$_3$ according to the experimental example of the present invention.

<Manufacture of Second Composite Substrate DEEC-SrTiO$_3$ According to Experimental Example of Present Invention>

In the method for manufacturing the first composite substrate according to the experimental example of the present invention described above, strontium titanate (SrTiO$_3$) was mixed instead of the barium titanate (BaTiO$_3$) to manufacture a second composite substrate DEEC-SrTiO$_3$ according to the experimental example of the present invention.

<Manufacture of Third Composite Substrate DEEC-Al$_2$O$_3$ According to Experimental Example of Present Invention>

In the method for manufacturing the first composite substrate according to the experimental example of the present invention described above, aluminum oxide (Al$_2$O$_3$) was mixed instead of the barium titanate (BaTiO$_3$) to manufacture a third composite substrate DEEC-Al$_2$O$_3$ according to the experimental example of the present invention.

<Preparation of First Stretchable Polymer Ecoflex According to Comparative Example>

In the method for manufacturing the first composite substrate according to the experimental example of the present invention described above, only ecoflex was prepared as the stretchable polymer to prepare the first stretchable polymer Ecoflex according to a comparative example.

<Preparation of Second Stretchable Polymer VHB According to Comparative Example>

In the method for manufacturing the first composite substrate according to the experimental example of the present invention described above, ecoflex and a polyacrylate-based polymer were prepared as stretchable polymers to prepare the first stretchable polymer Ecoflex according to the comparative example.

<Manufacture of First Substrate BaTiO$_3$-μP According to Comparative Example>

In the method for manufacturing the first composite substrate according to the experimental example of the present invention described above, water was not provided, and micro-sized barium titanate (BaTiO$_3$) powder serving as dielectric powder was mixed to manufacture a first substrate BaTiO$_3$-μP according to the comparative example.

<Manufacture of Second Substrates H-BaTiO$_3$, BaTiO$_3$-composite, And BaTiO$_3$ According to Comparative Example>

In the method for manufacturing the first composite substrate according to the experimental example of the present invention described above, water was not provided so as to manufacture second substrates H-BaTiO$_3$, BaTiO$_3$-composite, and BaTiO$_3$ according to the comparative example.

<Manufacture of Third Substrate SrTiO$_3$-composite According to Comparative Example>

In the method for manufacturing the second substrate according to the comparative example described above, strontium titanate (SrTiO$_3$) was mixed instead of barium titanate (BaTiO$_3$) to manufacture a third substrate SrTiO$_3$-composite according to the comparative example.

<Manufacture of Fourth Substrate Al$_2$O$_3$-composite According to Comparative Example>

In the method for manufacturing the second substrate according to the comparative example described above, aluminum oxide (Al$_2$O$_3$) was mixed instead of barium titanate (BaTiO$_3$) to manufacture a fourth substrate Al$_2$O$_3$-composite according to the comparative example.

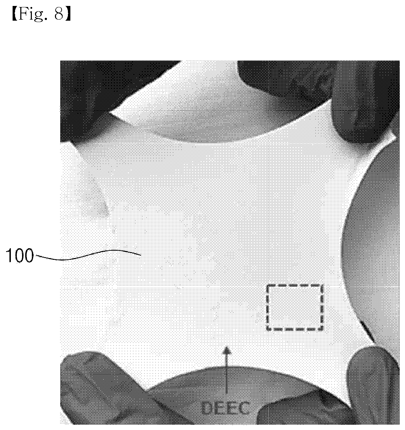

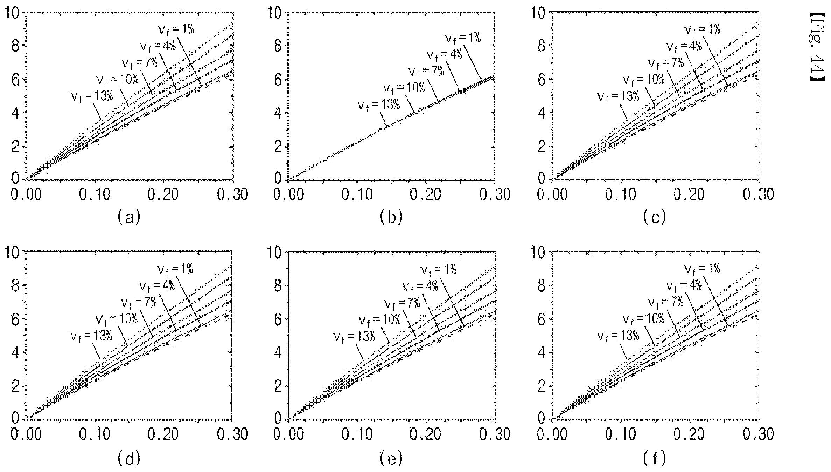

FIGS. 8 to 54 are views for explaining experimental examples of the present invention.

FIG. 8 is a photograph of the first composite substrate 100 according to the experimental example of the present invention.

Referring to FIG. 8, it may be proved that the first composite substrate 100 has elasticity.

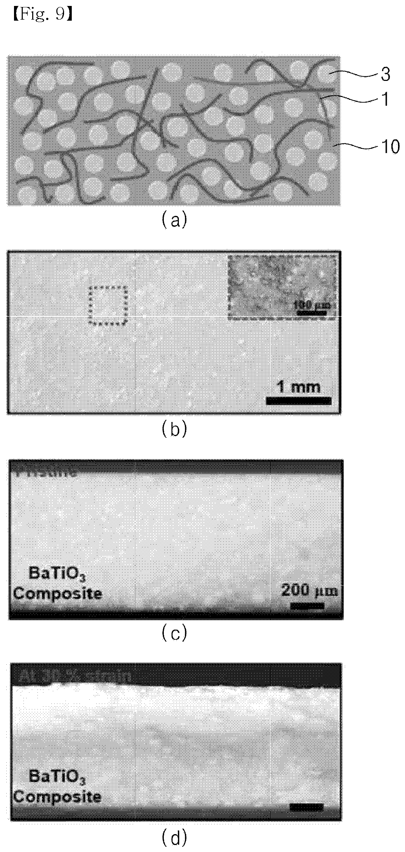

FIGS. 9(a) to 9(d) are photographs of the second substrate BaTiO$_3$-composite according to the comparative example.

Referring to FIGS. 9(a) to 9(d), it can be seen that the dielectric cluster 30 is not formed in the second substrate BaTiO$_3$-composite because water is not provided as the catalyst 4.

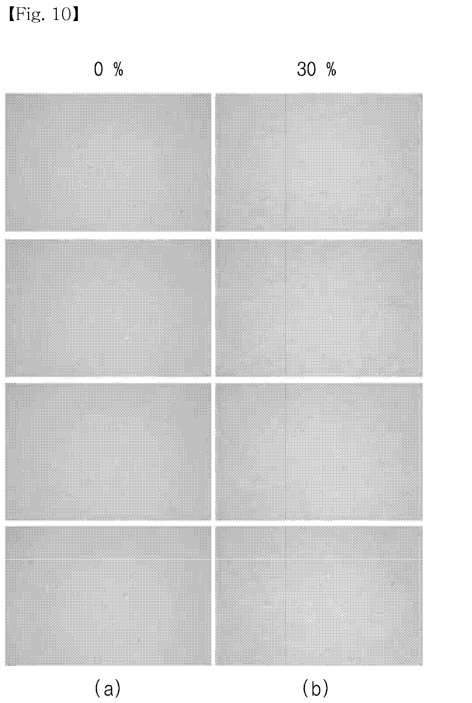

FIG. 10(a) is a photograph of the second substrate BaTiO$_3$-composite according to the comparative example before stretching, and FIG. 10(b) is a photograph of the second substrate BaTiO$_3$-composite according to the comparative example, which is stretched by 30%.

Through FIGS. 10(a) and 10(b), it can be seen that the dielectric cluster 30 is not formed in the second substrate BaTiO$_3$-composite because water is not provided as the catalyst 4.

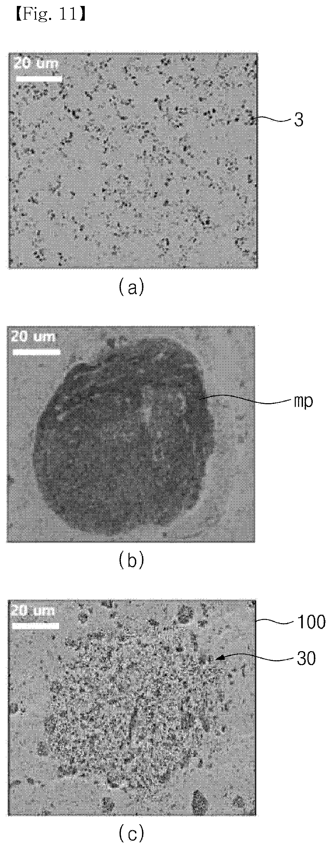

FIG. 11(a) is a photograph of the second substrate BaTiO$_3$-composite according to the comparative example, FIG. 11(b) is a photograph of the first substrate BaTiO$_3$-μP according to the comparative example, and FIG. 11(c) is a photograph of the first composite substrate 100 according to the experimental example of the present invention.

Referring to FIG. 11(a), it may be observed that the dielectric cluster 30 is not formed and the dielectric powder 3 is dispersed in the second substrate BaTiO$_3$-composite because water is not provided as the catalyst 4.

As in the second substrate BaTiO$_3$-composite, when the dielectric cluster 30 is not formed and the dielectric powder 3 is dispersed, the dielectric constant of the substrate may not rapidly decrease.

Referring to FIG. 11(b), barium titanate (BaTiO$_3$) particles mp having a size of several tens of micrometers may be observed in the first substrate BaTiO$_3$-$\mu$P.

As in the first substrate BaTiO$_3$-$\mu$P, when the barium titanate (BaTiO$_3$) particles (mp) having a size of several tens of micrometers are included, elasticity of the substrate may be deteriorated.

Referring to FIG. 11(c), the dielectric cluster 30 having a circular shape may be observed in the first composite substrate 100.

Thus, according to the experimental example of the present invention, it may be proved that the first composite substrate 100 includes the dielectric cluster 30 having a circular shape.

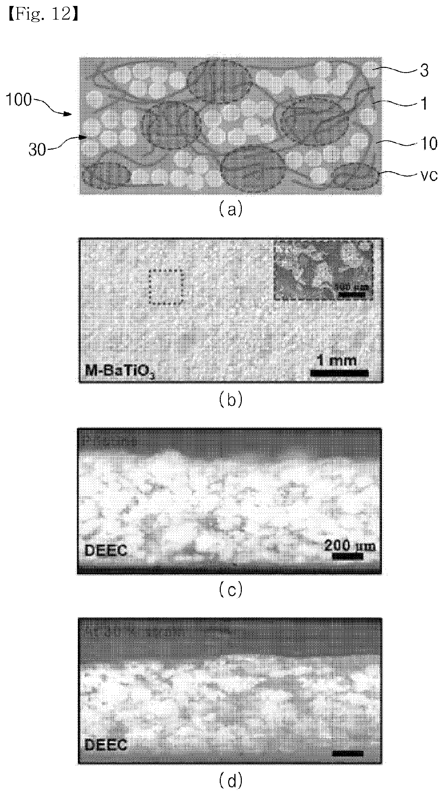

FIGS. 12(a) to 12(d) are photographs of the first composite substrates 100 and M-BaTiO$_3$ according to the experimental example of the present invention.

Through FIGS. 12(a) to 12(d), it may be proved that the first composite substrates 100 and M-BaTiO$_3$ include the dielectric cluster 30.

In addition, referring to FIGS. 12(a) to 12(d), since the first composite substrate 100 includes the dielectric cluster 30, it may also be observed that empty spots, that is, vacancies vc, which are moved by the attractive force af between the dielectric powders 3, are formed between the dielectric clusters 30.

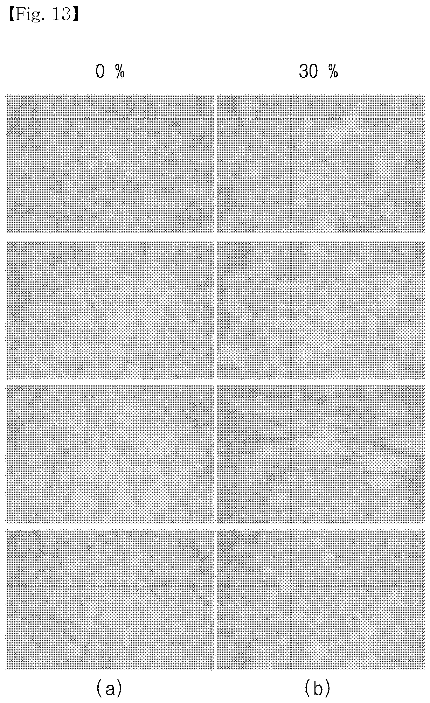

FIG. 13(a) is a photograph of the first composite substrate 100 according to the experimental example of the present invention before stretching, and FIG. 13(b) is a photograph of the first composite substrate 100 according to the experimental example of the present invention, which is stretched by 30%.

Through FIG. 13(a), the dielectric cluster 30 dispersed in the first composite substrate 100 may be observed.

Furthermore, through FIG. 13(b), when the first composite substrate 100 is stretched, a change in shape of the dielectric cluster 30 may be observed.

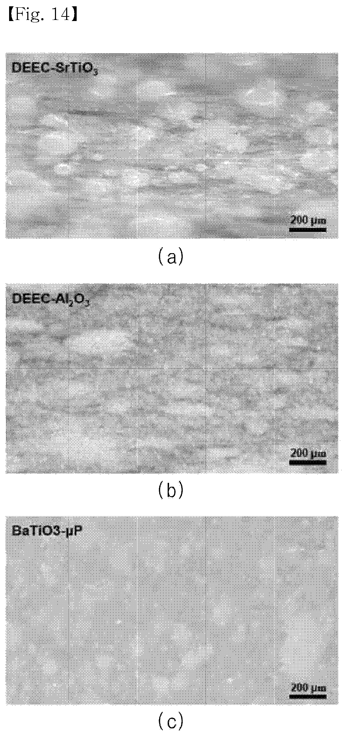

FIG. 14(a) is a photograph of the second composite substrate DEEC-SrTiO$_3$ according to the experimental example of the present invention before stretching, FIG. 14(b) is a photograph of the third composite substrate DEEC-Al$_2$O$_3$ according to the experimental example of the present invention before stretching, and FIG. 14(c) is a photograph of the first substrate BaTiO$_3$-$\mu$P according to the comparative example before stretching.

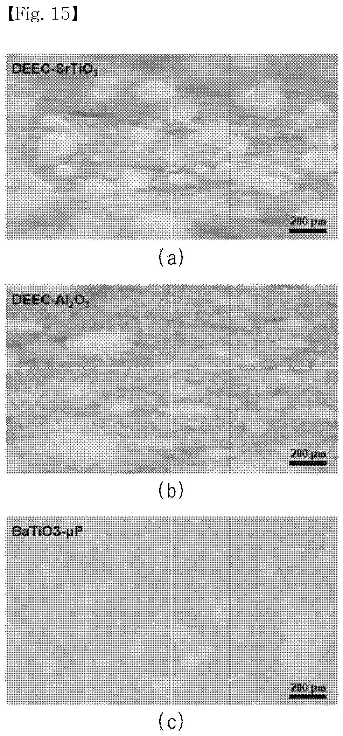

FIG. 15(a) is a photograph of the second composite substrate DEEC-SrTiO$_3$ according to the experimental example of the present invention, which is stretched by 30%, FIG. 15(b) is a photograph of the third composite substrate DEEC-Al$_2$O$_3$ according to the experimental example of the present invention, which is stretched by 30%, and FIG. 15(c) is a photograph of the first substrate BaTiO$_3$-$\mu$P according to the comparative example, which is stretched by 30%.

Referring to FIGS. 14(a) to 15(c), in the case of the second and third composite substrates DEEC-SrTiO$_3$ and DEEC-Al$_2$O$_3$ manufactured according to the experimental example of the present invention, it may be observed that the shape of the dielectric cluster 30 is changed when the second and third composite substrates DEEC-SrTiO$_3$ and DEEC-Al$_2$O$_3$ are stretched.

On the other hand, in the case of the first substrate BaTiO$_3$-$\mu$P manufactured according to the comparative example, the shape is not changed even when the first substrate BaTiO$_3$-$\mu$P is stretched.

This is because elasticity of the substrate may be deteriorated when the first substrate BaTiO$_3$-$\mu$P includes barium titanate (BaTiO$_3$) particles mp having a size of several tens of micrometers.

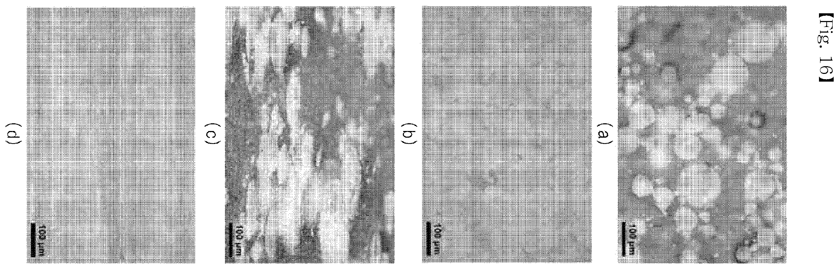

FIG. 16(a) is a photograph of the first composite substrate 100 according to the experimental example of the present invention before stretching, when a volume ratio occupied by the dielectric powder 3 is 1% (1 vol%), FIG. 16(b) is a photograph of the first composite substrate 100 according to the experimental example of the present invention before stretching, when a volume ratio occupied by the dielectric powder 3 is 10% (10 vol%), FIG. 16(c) is a photograph of the first composite substrate 100 according to the experimental example of the present invention, which is stretched by 30%, when a volume ratio occupied by the dielectric powder 3 is 1% (1 vol%), and FIG. 16(d) is a photograph of the first composite substrate 100 according to the experimental example of the present invention, which is stretched by 30%, when a volume ratio occupied by the dielectric powder 3 is 10% (10 vol%).

Referring to FIGS. 16(a) to 16(d), it may be observed that the shape of the dielectric cluster 30 is changed in all of the experimental examples of the present invention.

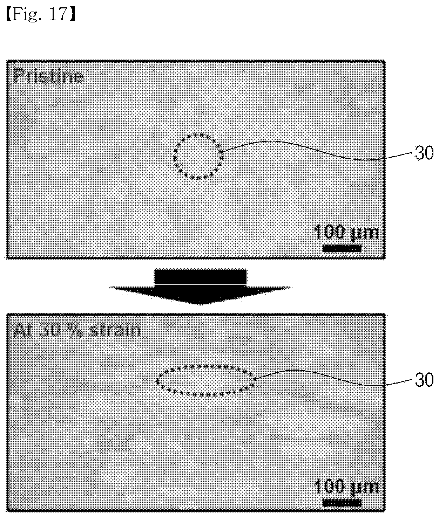

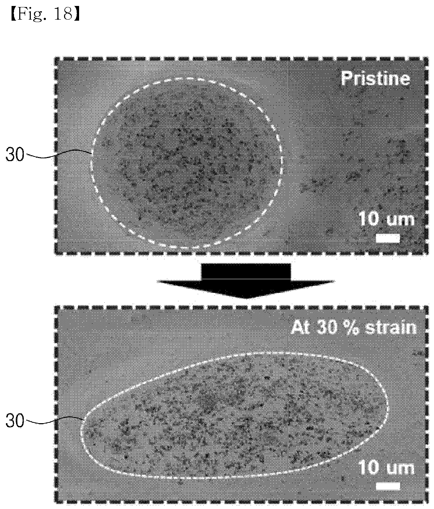

FIG. 17 is a 100 $\mu$m scale photograph of the first composite substrate 100 according to the experimental example of the present invention, before stretching and after stretched by 30%, and FIG. 18 is a 10 $\mu$m scale photograph of the first composite substrate 100 according to the experimental example of the present invention, before stretching and after stretched by 30%.

Referring to FIGS. 17 and 18, a change in shape of the dielectric cluster 30 may be observed in the first composite substrate 100.

More specifically, it may be observed that the dielectric cluster 30 having a circular shape before stretching is changed into an elliptical shape after stretched by 30% in the first composite substrate 100.

Accordingly, when the first composite substrate 100 is stretched, it may be proved that the shape of the dielectric cluster 30 is changed such that the number of the dielectric powders 3 per unit volume of the stretchable polymer matrix 10 decreases.

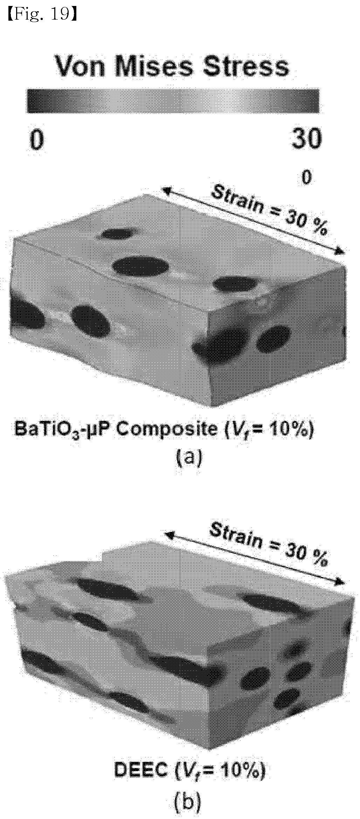

FIG. 19(a) is an elasticity simulation result when the first substrate $BaTiO_3$-$\mu$P according to the comparative example is stretched by 30%, and FIG. 19(b) is an elasticity simulation result when the first composite substrate DEEC according to the experimental example of the present invention is stretched by 30%.

Referring to FIGS. 19(a) and 19(b), it may be proved that elasticity of the first composite substrate DEEC is superior to that of the first substrate $BaTiO_3$-$\mu$P.

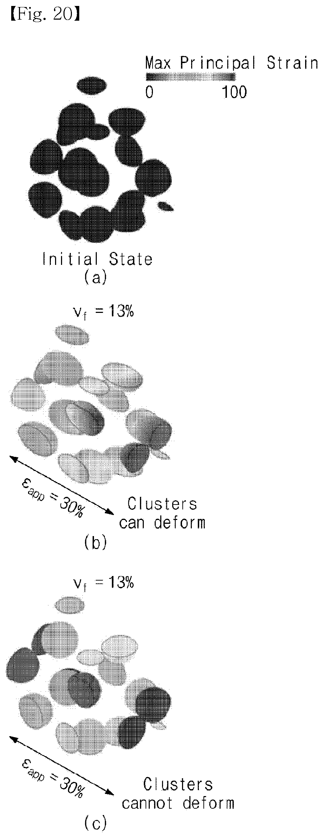

FIG. 20(a) is a simulation result of the first composite substrate 100 according to the experimental example of the present invention before stretching, FIG. 20(b) is a simulation result of the first composite substrate 100 according to the experimental example of the present invention, which is stretched by 30%, when a volume ratio occupied by the dielectric powder 3 is 13% (13 vol%), and FIG. 20(c) is a simulation result of the first substrate $BaTiO_3$-$\mu$P according to the comparative example, which is stretched by 30%, when a volume ratio occupied by the dielectric powder is 13% (13 vol%).

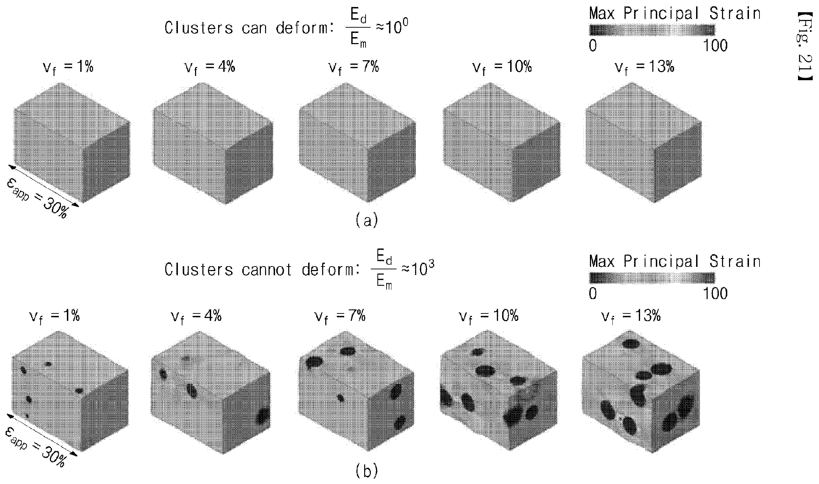

FIG. 21(a) is a simulation result of the first composite substrate 100 according to the experimental example of the present invention, which is stretched by 30%, when a volume ratio occupied by the dielectric powder 3 is 1% to 13% (1 to 13 vol%), and FIG. 21(b) is a simulation result of the first substrate $BaTiO_3$-$\mu$P according to the comparative example, which is stretched by 30%, when a volume ratio occupied by the dielectric powder 3 is 1% to 13% (1 to 13 vol%).

Through FIGS. 20(a) to 21(b), it may be proved that elasticity of the first composite substrate DEEC is superior to that of the first substrate $BaTiO_3$-$\mu$P.

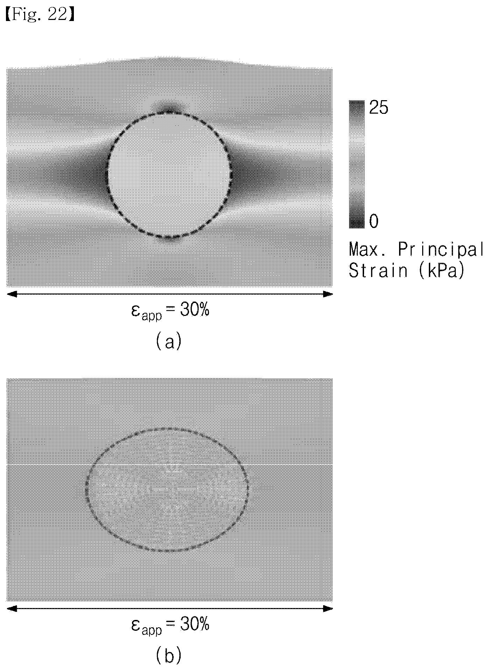

FIG. 22(a) is an elasticity simulation result when the first substrate $BaTiO_3$-$\mu$P according to the comparative example is stretched by 30%, and FIG. 22(b) is an elasticity simulation result when the first composite substrate 100 according to the experimental example of the present invention is stretched by 30%.

Through FIGS. 22(a) and 22(b), it may be proved that elasticity of the first composite substrate DEEC is superior to that of the first substrate $BaTiO_3$-$\mu$P.

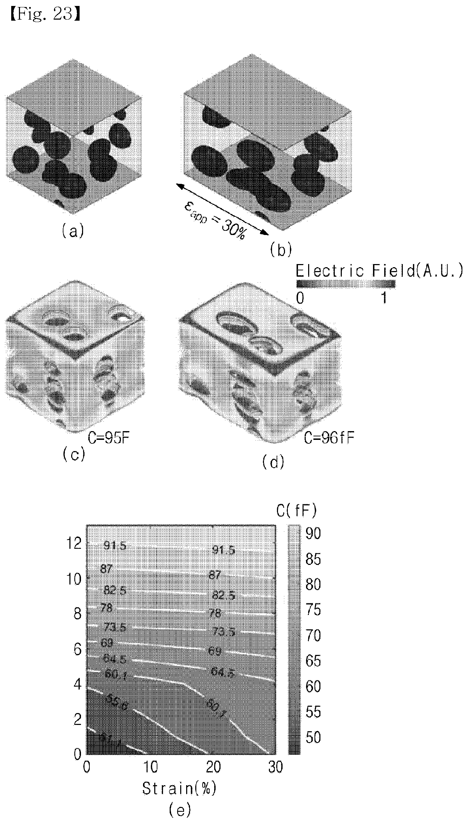

FIGS. 23(a) and 23(c) are capacitance simulation results of the first composite substrate 100 according to the experimental example of the present invention before stretching, FIGS. 23(b) and 23(d) are capacitance simulation results when the first composite substrate 100 according to the experimental example of the present invention is stretched by 30%, and FIG. 23(e) is a capacitance simulation legend.

Referring to FIGS. 23(a) to 23(e), it may be proved that the first composite substrate 100 has a uniform capacitance distribution even when the first composite substrate 100 is stretched by 30%.

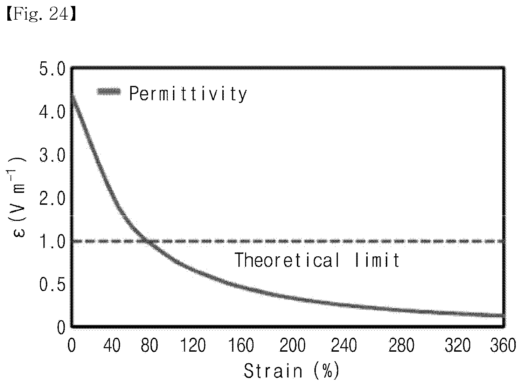

FIG. 24 is a dielectric constant (permittivity) change simulation curve required when a substrate having elasticity and dielectric properties is stretched.

Referring to FIG. 24, when a theoretical limit is excluded from a substrate having elasticity and a dielectric constant, a simulation result shows that dielectric constant may decrease with a gradient in a range of 0.043 to 0.044 in a stretch range of 0.1% to 80%.

Referring to FIG. 26, this is a result of a gentle gradient as compared to a case where the dielectric constant of the first composite substrate DEEC according to the experimental example of the present invention, which will be described later, decreases with a gradient in a range of 0.03 to 0.08 in a stretch range of 0.1% to 30%.

Therefore, according to the experimental example of the present invention, it may be proved that the first composite substrate DEEC has a dielectric constant that rapidly decreases as compared to the simulation result.

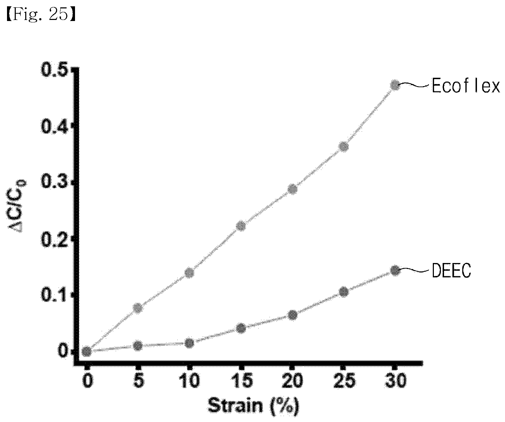

FIG. 25 is a result of measuring a capacitance change according to elongation of the first composite substrate DEEC according to the experimental example of the present invention and the first stretchable polymer Ecoflex according to the comparative example.

Referring to FIG. 25, it may be proved that the first composite substrate DEEC may have a capacitance change less than that of the first substrate polymer Ecoflex when the first composite substrate DEEC is stretched by 30%.

FIG. 26 is a result of measuring dielectric constants $\varepsilon$ of the first composite substrate DEEC according to the experimental example of the present invention, the first substrate $BaTiO_3$-$\mu$P according to the comparative example, the second substrate H-$BaTiO_3$ according to the comparative example, and the first stretchable polymer Ecoflex according to the comparative example, in a stretch (strain) range of 0.1% to 30%.

Referring to FIG. 26, it can be seen that the first composite substrate DEEC has a variable dielectric constant range as described above in the stretch range of 0.1% to 30%. More specifically, it can be seen that the first composite substrate DEEC has a variable dielectric constant in a range of 1.5 to 7.5, as shown in FIG. 26.

In addition, referring to FIG. 26, it can be seen that the dielectric constant of the first composite substrate DEEC rapidly decreases with a gradient in a range of 0.03 to 0.08 in the stretch range of 0.1% to 30%.

Accordingly, according to the present invention, when the first composite substrates DEEC and 100 are applied to the high-frequency device as described above, the first composite substrates DEEC and 100 may have excellent frequency characteristics.

This is because, according to the experimental example of the present invention, when the first composite substrates DEEC and 100 are stretched as described above, the shape of the dielectric cluster 30 is changed so that the dielectric constant is varied.

Meanwhile, it can be seen that the gradients of the second substrate H-BaTiO$_3$, the first substrate BaTiO$_3$-$\mu$P, and the first stretchable polymer Ecoflex are gentle as compared to the experimental example of the present invention.

Among the second substrate H-BaTiO$_3$, the first substrate BaTiO$_3$-$\mu$P, and the first stretchable polymer Ecoflex, as can be seen in the second substrate H-BaTiO$_3$ having a gradient that most rapidly decreases, the dielectric constant of the second substrate H-BaTiO$_3$ decreases with a gradient in a range of 0.025 in the stretch range of 0.1% to 30%.

Therefore, referring to the fact that the dielectric constant decreases with a gradient in a range of 0.043 to 0.044 in the stretch range of 0.1% to 80% as the simulation result described above with reference to FIG. 24, it may be proved that the gradient decreases most rapidly in the experimental example of the present invention.

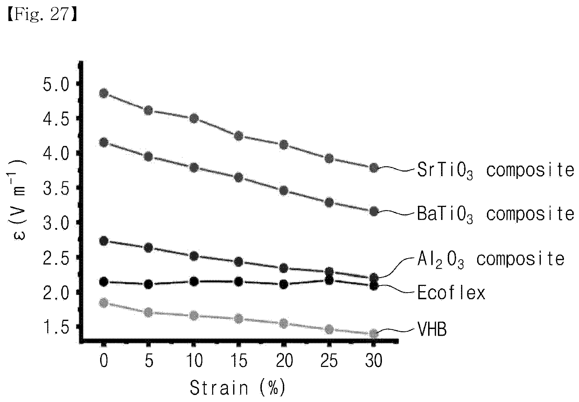

FIG. 27 shows a result of measuring dielectric constants $\varepsilon$ of the second substrate BaTiO$_3$-composite according to the comparative example, the third substrate SrTiO$_3$-composite according to the comparative example, the fourth substrate Al$_2$O$_3$-composite according to the comparative example, the first stretchable polymer Ecoflex according to the comparative example, and the second stretchable polymer VHB according to the comparative example, in a stretch (strain) range of 0.1% to 30%.

Referring to FIG. 27, it can be seen that when barium titanate (BaTiO$_3$) and strontium titanate (SrTiO$_3$) are included as the dielectric powder 3 in the stretch range of 0.1% to 30%, the dielectric constant decreases with a steeper gradient than the gradients of other comparative examples.

Therefore, when barium titanate (BaTiO$_3$) and/or strontium titanate (SrTiO$_3$) are included as the dielectric powder 3, it may be proved that the dielectric powder has excellent dielectric constant characteristics for stretching.

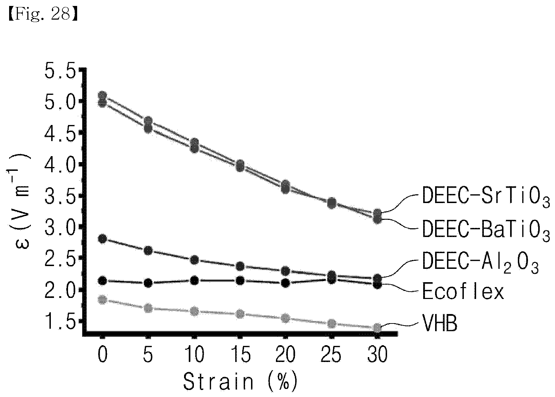

FIG. 28 is a result of measuring dielectric constants $\varepsilon$ of the first composite substrate DEEC-BaTiO$_3$ according to the experimental example of the present invention, the second composite substrate DEEC-SrTiO$_3$ according to the experimental example of the present invention, the third composite substrate DEEC-Al$_2$O$_3$ according to the experimental example of the present invention, the first stretchable polymer Ecoflex according to the comparative example, and the second stretchable polymer VHB according to the comparative example, in a stretch (strain) range of 0.1% to 30%.

Referring to FIG. 28, it can be seen that the dielectric constants of the first and second composite substrates DEEC-BaTiO$_3$ and DEEC-SrTiO$_3$ rapidly decrease with a gradient in a range of 0.03 to 0.08 in the stretch range of 0.1% to 30%.

Accordingly, according to the present invention, when the first and second composite substrates DEEC-BaTiO$_3$ and DEEC-SrTiO$_3$ are applied to the high-frequency device as described above, it may be proved that the first and second composite substrates DEEC-BaTiO$_3$ and DEEC-SrTiO$_3$ may have excellent frequency characteristics.

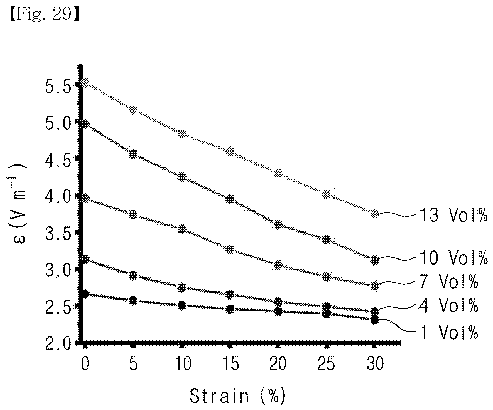

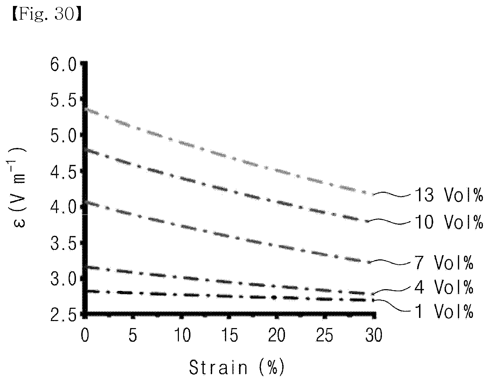

FIGS. 29 and 30 are results of stretching the first composite substrate 100 according to the experimental example of the present invention in a stretch range of 0.1% to 30% when a volume ratio occupied by the dielectric powder 3 is 1% to 13 (1 to 13 vol%).

Referring to FIGS. 29 and 30, it can be seen that the dielectric constant of the first composite substrate 100 rapidly decreases as the volume ratio occupied by the dielectric powder 3 increases.

Meanwhile, when the volume ratio occupied by the dielectric powder 3 is greater than 7% and equal to or less than 13% it can be seen that the dielectric constant of the first composite substrate 100 is maintained with a gradient in a range of 0.058 to 0.059.

Accordingly, according to the experimental example of the present invention, it may be proved that the first composite substrate 100 includes the dielectric powder 3 in the volume ratio of greater than 7% and equal to or less than 13% in consideration of a relationship between the stretched length, the dielectric constant, and the frequency as described above, thereby improving frequency characteristics of the high-frequency device.

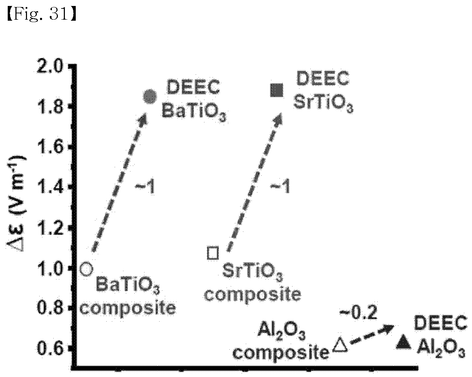

FIG. 31 is a result of measuring changes in dielectric constant of the first composite substrate DEEC-BaTiO$_3$ according to the experimental example of the present invention, the second composite substrate DEEC-SrTiO$_3$ according to the experimental example of the present invention, and the third composite substrate DEEC-Al$_2$O$_3$ according to the experimental example of the present invention.

Referring to FIG. 31, through the experiment of the present invention, it can be seen that when barium titanate (BaTiO$_3$) and strontium titanate (SrTiO$_3$) are used as the dielectric powder 3, dielectric constant change characteristics are superior to those when aluminum oxide (Al$_2$O$_3$) is used.

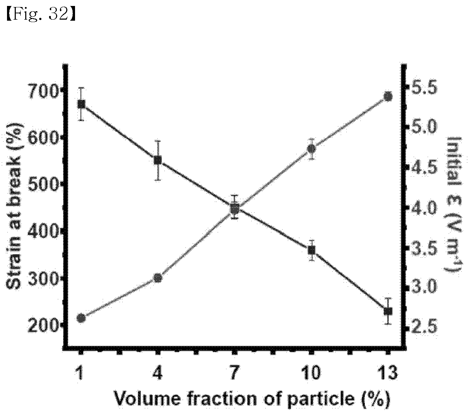

FIG. 32 is a result of measuring a relationship between a strain at break and an initial dielectric constant of the first composite substrate 100 according to the experimental example of the present invention according to the volume ratio occupied by the dielectric powder 3.

Referring to FIG. 32, it can be seen that as the volume ratio occupied by the dielectric powder 30 increases, the strain at break of the first composite substrate 100 decreases, but the initial dielectric constant thereof increases.

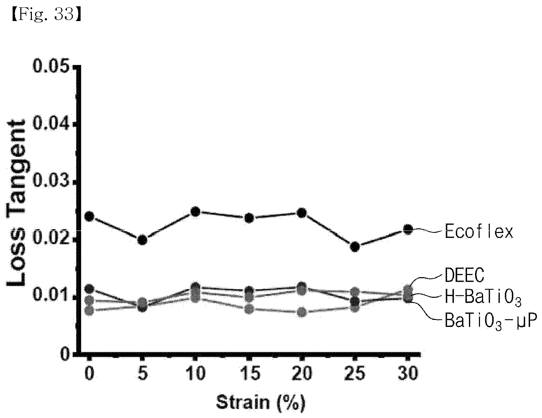

FIG. 33 is a result of measuring dielectric losses (Loss Tangent) of the first composite substrate DEEC according to the experimental example of the present invention, the first substrate BaTiO$_3$-$\mu$P according to the comparative example, the second substrate H-BaTiO$_3$ according to the comparative example, and the first stretchable polymer Ecoflex according to the comparative example, in a stretch (strain) range of 0.1% to 30%.

Referring to FIG. 33, the dielectric loss of the first composite substrate DEEC is less than that of other comparative examples, and it can be seen that the dielectric loss is maintained constant even when the first composite substrate DEEC is stretched in the stretch range of 0.1% to 30%.

Accordingly, excellent dielectric constant characteristics of the composite substrate 100 manufactured according to the experimental example of the present invention may be proved.

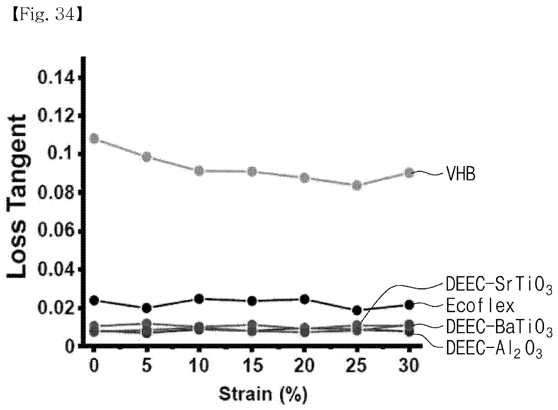

FIG. 34 is a result of measuring dielectric losses (Loss Tangent) of the first composite substrate DEEC-BaTiO$_3$ according to the experimental example of the present invention, the second composite substrate DEEC-SrTiO$_3$ according to the experimental example of the present invention, the third composite substrate DEEC-Al$_2$O$_3$ according to the experimental example of the present invention, the first stretchable polymer Ecoflex according to the comparative example, and the second stretchable polymer VHB according to the comparative example, in a stretch (strain) range of 0.1% to 30%.

Referring to FIG. 34, it can be seen that the dielectric losses of the first to third composite substrates DEEC-BaTiO$_3$, DEEC-SrTiO$_3$, and DEEC-Al$_2$O$_3$ are similar, but are less than that of other comparative examples, and the dielectric losses are maintained constant even when the first to third composite substrates DEEC-BaTiO$_3$, DEEC-SrTiO$_3$, and DEEC-Al$_2$O$_3$ are stretched in the stretch range of 0.1% to 30%.

Accordingly, excellent dielectric constant characteristics of the composite substrate 100 manufactured according to the experimental example of the present invention may be proved.

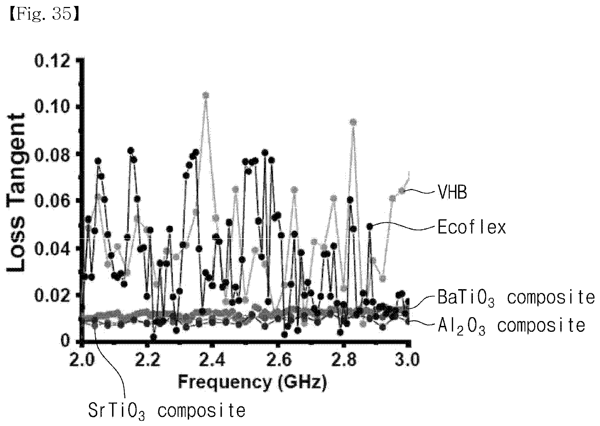

FIG. 35 is a result of measuring dielectric losses (Loss Tangent) of the second substrate BaTiO$_3$-composite according to the comparative example, the third substrate SrTiO$_3$-composite according to the comparative example, the fourth substrate Al$_2$O$_3$-composite according to the comparative example, the first stretchable polymer Ecoflex according to the comparative example, and the second stretchable polymer VHB according to the comparative example, in a frequency range of 2.0 to 3.0.

Referring to FIG. 35, among the comparative examples, when barium titanate (BaTiO$_3$), strontium titanate (SrTiO$_3$), and aluminum oxide (Al$_2$O$_3$) are included as the dielectric powder 3, it can be seen that the dielectric loss is small and is maintained relatively constant in a frequency range of 2.0 to 3.0.

On the other hand, among the comparative examples, in a case where the dielectric powder 3 is not included, that is, in a case of being formed of only the stretchable polymer materials Ecoflex and VHB, it can be seen that the dielectric loss is large and irregularly increased and decreased in the frequency range of 2.0 to 3.0.

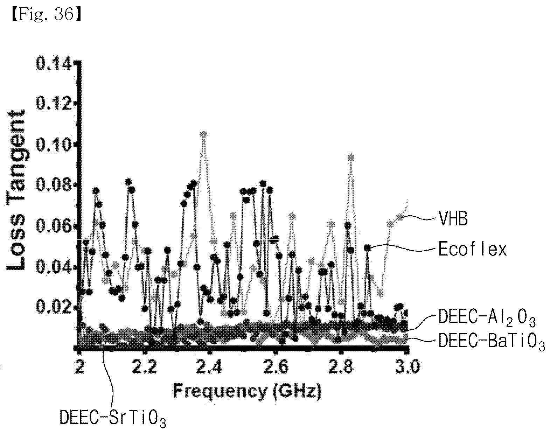

FIG. 36 is a result of measuring dielectric losses (Loss Tangent) of the first composite substrate DEEC-BaTiO$_3$ according to the experimental example of the present invention, the second composite substrate DEEC-SrTiO$_3$ according to the experimental example of the present invention, the third composite substrate DEEC-Al$_2$O$_3$ according to the experimental example of the present invention, the first stretchable polymer Ecoflex according to the comparative example, and the second stretchable polymer VHB according to the comparative example, in a frequency range of 2.0 to 3.0.

Referring to FIG. 36, when barium titanate (BaTiO$_3$), strontium titanate (SrTiO$_3$), and aluminum oxide (Al$_2$O$_3$) are included as the dielectric powder 3 according to the experimental example of the present invention, it can be seen that the dielectric loss is small and is maintained constant in the frequency range of 2.0 to 3.0 as compared to the second substrate BaTiO$_3$-composite according to the comparative example, the third substrate SrTiO$_3$-composite according to the comparative example, and the fourth substrate Al$_2$O$_3$-composite according to the comparative example.

Thus, according to the experimental example of the present invention, when water is provided as the catalyst 4, since the dielectric cluster 30 is formed, it may be proved that the manufactured composite substrate 100 has excellent dielectric constant characteristics.

On the other hand, as described above, among the comparative examples, in a case where the dielectric powder 3 is not included, that is, in a case of being formed of only the stretchable polymer materials Ecoflex and VHB, it can be seen that the dielectric loss is large and irregularly increased and decreased in the frequency range of 2.0 to 3.0.

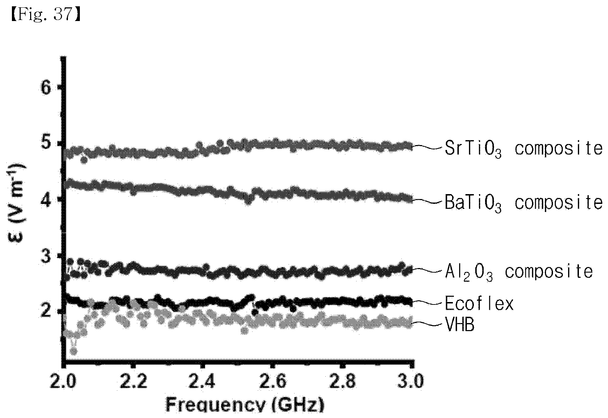

FIG. 37 is a result of measuring dielectric constants of the second substrate BaTiO$_3$-composite according to the comparative example, the third substrate SrTiO$_3$-composite according to the comparative example, the fourth substrate Al$_2$O$_3$-composite according to the comparative example, the first stretchable polymer Ecoflex according to the comparative example, and the second stretchable polymer VHB according to the comparative example, in a frequency range of 2.0 to 3.0.

Referring to FIG. 37, among the comparative examples, when barium titanate (BaTiO$_3$), strontium titanate (SrTiO$_3$), and aluminum oxide (Al$_2$O$_3$) are included as the dielectric powder 3, it can be seen that the dielectric constant is high and is maintained relatively constant as compared to other comparative examples (Ecoflex and VHB) in the frequency range of 2.0 to 3.0.

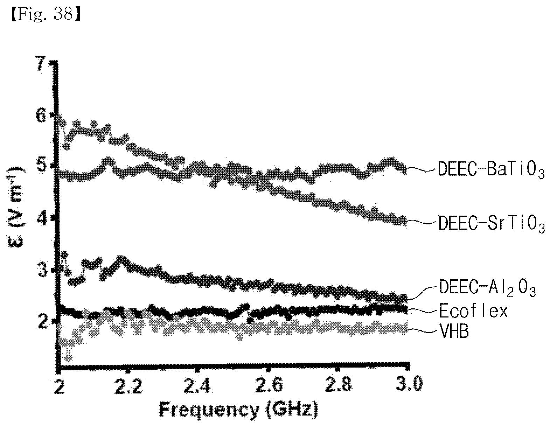

FIG. 38 is a result of measuring dielectric constants of the first composite substrate DEEC-BaTiO$_3$ according to the experimental example of the present invention, the second composite substrate DEEC-SrTiO$_3$ according to the experimental example of the present invention, the third composite substrate DEEC-Al$_2$O$_3$ according to the experimental example of the present invention, the first stretchable polymer Ecoflex according to the comparative example, and the second stretchable polymer VHB according to the comparative example, in a frequency range of 2.0 to 3.0.

Referring to FIG. 38, when barium titanate ($BaTiO_3$) and strontium titanate ($SrTiO_3$) are included as the dielectric powder 3 according to the experimental example of the present invention, it can be seen that the dielectric loss is high in the frequency range of 2.0 to 3.0 as compared to the comparative examples described above, that is, the second substrate $BaTiO_3$-composite according to the comparative example and the third substrate $SrTiO_3$-composite according to the comparative example.

Thus, according to the experimental example of the present invention, when water is provided as the catalyst 4, since the dielectric cluster 30 is formed, it may be proved that the manufactured composite substrate 100 has excellent dielectric constant characteristics.

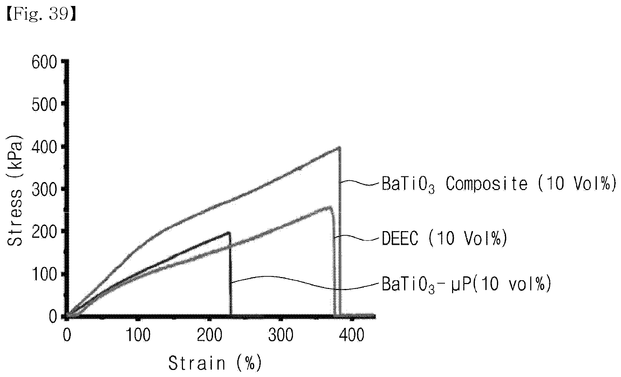

FIG. 39 is a result of measuring strains according to the applied stress in the first composite substrate DEEC according to the experimental example of the present invention, the first substrate $BaTiO_3$-$\mu$P according to the comparative example, and the second substrate $BaTiO_3$-composite according to the comparative example, when a volume ratio occupied by the dielectric powder 3 is 10% (10 vol%).

Referring to FIG. 39, it can be seen that the maximum strains of the first composite substrate DEEC and the second substrate $BaTiO_3$-composite according to the stress are similar, whereas the maximum strain of the first substrate $BaTiO_3$-$\mu$P according to the stress is about half of that of the first composite substrate DEEC and the second substrate $BaTiO_3$-composite.

Therefore, according to the experimental example of the present invention, when the dielectric cluster 30 is included, as described above, it can be seen that not only the dielectric constant is excellent, but also the strain according to the applied stress has a level similar to that of the substrate (the second substrate $BaTiO_3$-composite) including the nanoparticle-sized dielectric powder **3**.

On the other hand, it can be seen that the strain according to the applied stress is weak in the first substrate $BaTiO_3$-$\mu$P including the dielectric powder 30 in a micro size.

Accordingly, according to the experimental example of the present invention, excellent elasticity of the first composite substrates 100 and DEEC may be proved.

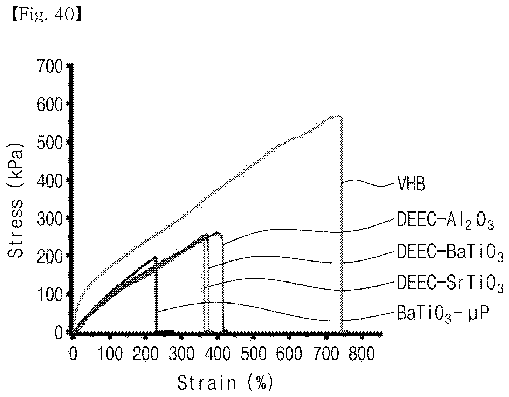

FIG. 40 is a result of measuring strains of the first composite substrate DEEC-$BaTiO_3$ according to the experimental example of the present invention, the second composite substrate DEEC-$SrTiO_3$ according to the experimental example of the present invention, the third composite substrate DEEC-$Al_2O_3$ according to the experimental example of the present invention, the first substrate $BaTiO_3$-$\mu$P according to the comparative example, and the second stretchable polymer VHB according to the comparative example, according to the applied stress.

Referring to FIG. 40, it can be seen that the maximum strains according to the stress of the first to third composite substrates DEEC-$BaTiO_3$, DEEC-$SrTiO_3$, and DEEC-$Al_2O_3$ are similar, but are superior to the maximum strain according to the stress of the first substrate $BaTiO_3$-$\mu$P.

Thus, according to the experimental example of the present invention, when barium titanate ($BaTiO_3$), strontium titanate ($SrTiO_3$), and aluminum oxide ($Al_2O_3$) are included as the dielectric powder 3, it can be seen that, as described above, not only the dielectric constant is excellent, but also the strain according to the applied stress is excellent due to the dielectric cluster 30 manufactured from the dielectric powder **3**.

Therefore, according to the experimental example of the present invention, excellent elasticity of the first composite substrate 100 may be proved.

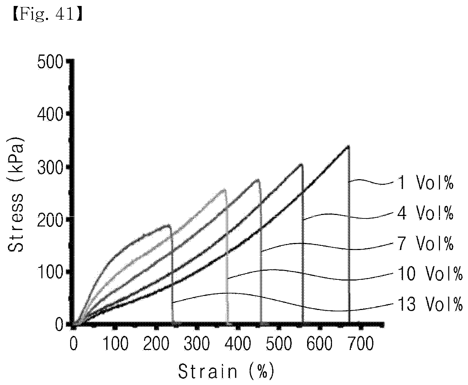

FIG. 41 is a result of measuring a strain of the first composite substrate 100 according to the experimental example of the present invention according to the applied stress, when a volume ratio occupied by the dielectric powder 3 is 1% to 13% (1 to 13 vol%).

Referring to FIG. 41, it can be seen that as the volume ratio occupied by the dielectric powder 3 increases, the maximum strain of the first composite substrate 100 according to the stress decreases.

This may be because as the volume ratio of the first composite substrate 100, which is occupied by the dielectric powder 3, increases, the volume ratio of the first composite substrate 100, which is occupied by the stretchable polymer 1, relatively decreases.

However, according to the experimental example of the present invention, even when the volume ratio of the first composite substrate 100, which is occupied by the dielectric powder 3, increases to 1% to 13% (1 to 13 vol%), it can be seen that the maximum strain of the first composite substrate 100 according to the stress is superior to the maximum strain of the first substrate $BaTiO_3$-$\mu$P according to the stress described above.

Therefore, according to the experimental example of the present invention, excellent elasticity of the first composite substrate 100 may be proved.

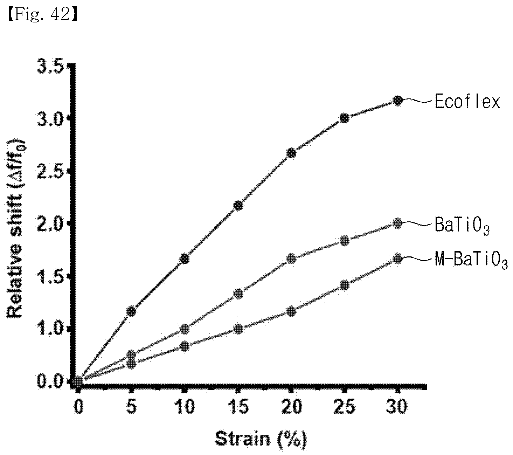

FIG. 42 is a result of measuring frequency shifts ($\Delta f/f_0$) of the first composite substrate M-$BaTiO_3$ according to the experimental example of the present invention, the second substrate $BaTiO_3$ according to the comparative example, and the first stretchable polymer Ecoflex according to the comparative example, in a stretch (strain) range of 0.1% to 30%.

Referring to FIG. 42, it can be seen that the composite substrate (the first composite substrate M-$BaTiO_3$)

according to the experimental example of the present invention has the lowest frequency shift in the stretch range of 0.1% to 30%.

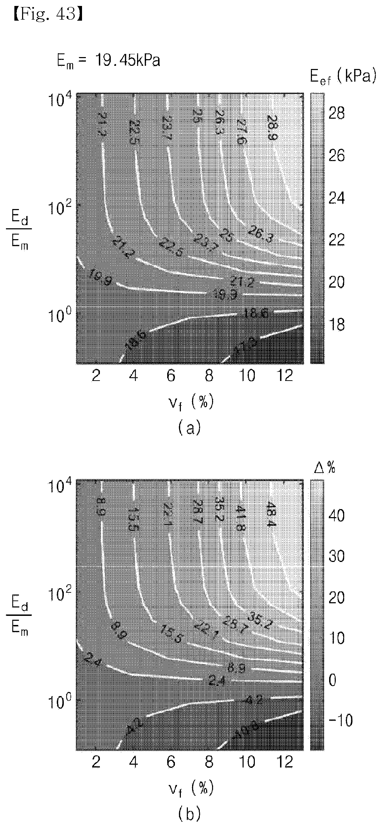

FIGS. 43(a) to 44(f) are simulation results of the first composite substrate 100 according to the experimental example of the present invention according to the application of stress of 19.45 kPa, when the volume ratio occupied by the dielectric powder 3 is 1% to 13% (1 to 13 vol%).

Referring to FIGS. 43(a) to 44(f), it can be seen that as the volume ratio of the first composite substrate 100, which is occupied by the dielectric powder 3, increases, the stress per unit volume increases.

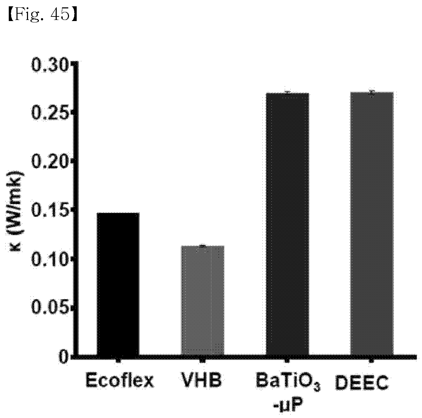

FIG. 45 is a result of measuring thermal conductivities of the first composite substrate DEEC according to the experimental example of the present invention, the first substrate $BaTiO_3$-$\mu P$ according to the comparative example, the first stretchable polymer Ecoflex according to the comparative example, and the second stretchable polymer VHB according to the comparative example.

Referring to FIG. 45, the first composite substrate DEEC may have a thermal conductivity of 0.1 W/mk to 10 W/mk.

This may be because, according to the experimental example of the present invention, the composite substrate 100 includes the dielectric powder 3, as described above.

Accordingly, according to the present invention, as described above, when the composite substrate 100 is applied to the high-frequency device, the composite substrate 100 may have excellent thermal conductivity characteristics.

FIG. 46 is a result of measuring a change in dielectric constant ($\Delta\varepsilon$), a dielectric loss (Loss Tangent), elasticity (Stretchability), a thermal conductivity (k), and a Young's modulus of the first composite substrate DEEC according to the experimental example of the present invention, the first substrate $BaTiO_3$-$\mu P$ according to the comparative example, the second substrate H-$BaTiO_3$ according to the comparative example, and the first stretchable polymer Ecoflex according to the comparative example.

Referring to FIG. 46, it can be seen that the first composite substrate DEEC has balanced and excellent change in dielectric constant, dielectric loss, elasticity, thermal conductivity, and Young's modulus.

Accordingly, according to the experimental example of the present invention, it may be proved that the first composite substrates 100 and DEEC may be applied to the high-frequency device of a flexible system.

Accordingly, in the experimental example of the present invention which will be described later, materials prepared according to the above-described experimental examples and comparative examples of the present invention are applied to an antenna at as shown in FIG. 47, and frequency characteristics are examined.

FIG. 47(a) is a conceptual view of an experiment for applying the first composite substrate 100 according to the experimental example of the present invention to the antenna at, FIG. 47(b) is a photograph of an experimental setting for applying the first composite substrate 100 according to the experimental example of the present invention to the antenna at, and FIG. 47(c) is a conceptual view of frequency characteristics when stretching is performed in a typical dielectric.

Referring to FIG. 47(a), in order to apply the first composite substrate 100 to the antenna at, a ground panel gd may be formed on a lower surface of the first composite substrate 100, and a patch pc may be formed on an upper surface of the first composite substrate 100.

Meanwhile, referring to FIG. 47(b), the antenna ac manufactured according to the above-described experimental conceptual view of FIG. 47(a) may be observed. As described above, it can be seen that the manufactured antenna at has excellent stretching characteristics because the first composite substrate 100 has elasticity.

Meanwhile, the above-described experiments according to FIGS. 47(a) and 47(b) are applied not only to the embodiment of the present invention but also to the comparative examples described above. In other words, in the above-described experiments according to FIGS. 47(a) and 47(b), the above-described experimental examples and comparative examples of the present invention are applied to the substrate.

Meanwhile, referring to FIG. 47(c), as described above, in a case where an antenna including a typical dielectric as a substrate, when the antenna is stretched, the dielectric constant may change.

However, according to the present invention, when the first composite substrate 100 is applied to the high-frequency device, the first composite substrate 100 may maintain a constant frequency.

Hereinafter, frequency characteristics according to the experimental example will be described.

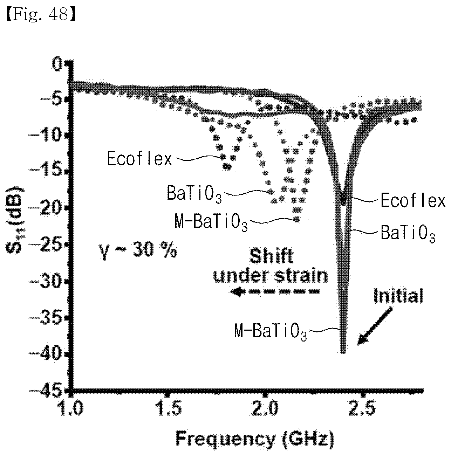

FIG. 48 is a result of simulating frequency characteristics of the first composite substrate M-$BaTiO_3$ according to the experimental example of the present invention, the second substrate $BaTiO_3$ according to the comparative example, and the first stretchable polymer Ecoflex according to the comparative example, when the first composite substrate M-$BaTiO_3$, the second substrate $BaTiO_3$, and the first stretchable polymer Ecoflex are stretched.

Referring to FIG. 48, as the simulation result, it is predicted that the frequency shift of the first composite substrate M-$BaTiO_3$ may be the least when the first composite substrate M-$BaTiO_3$, the second substrate $BaTiO_3$, and the first stretchable polymer Ecoflex are stretched.

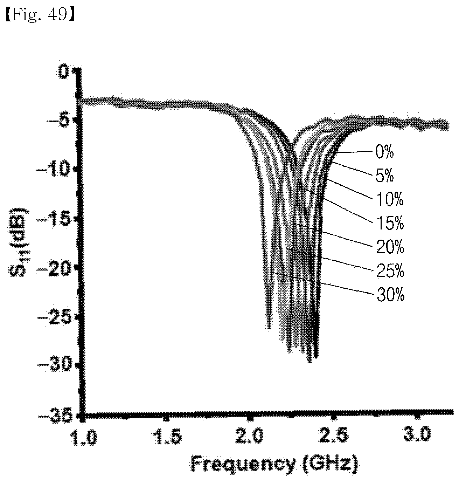

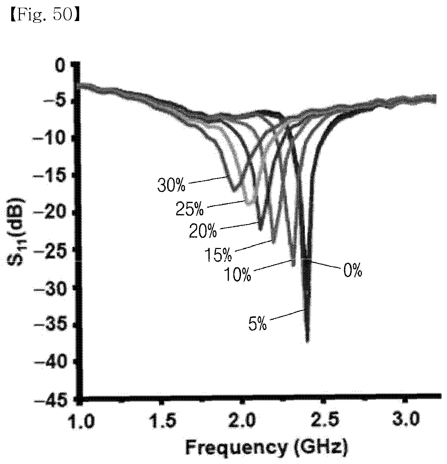

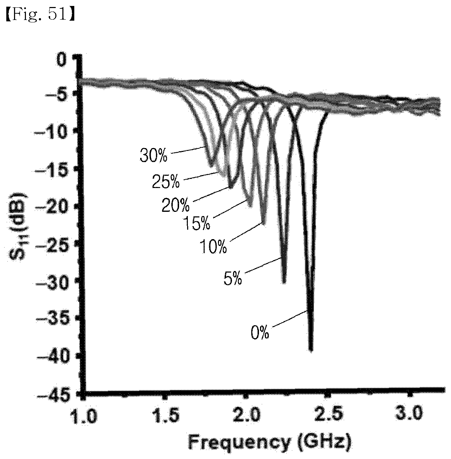

FIG. 49 is a result of simulating frequency characteristics when the first composite substrate M-$BaTiO_3$ according to the experimental example of the present invention is stretched in a stretch range of 0.1% to 30%, FIG. 50 is a result of simulating frequency characteristics when the second substrate BaTiO$_3$ according to the comparative example is stretched in a stretch range of 0.1% to 30%, and FIG. 51 is a result of simulating frequency characteristics when the first stretchable polymer Ecoflex according to the comparative example is stretched in a stretch range of 0.1% to 30%.

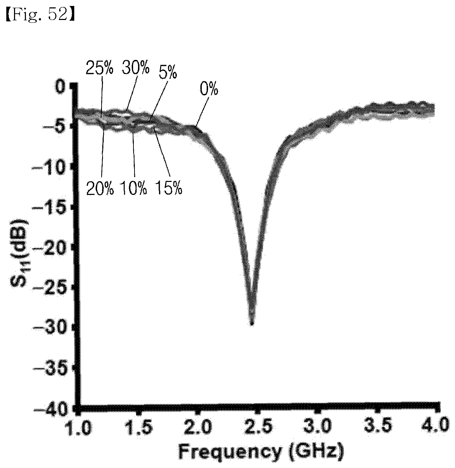

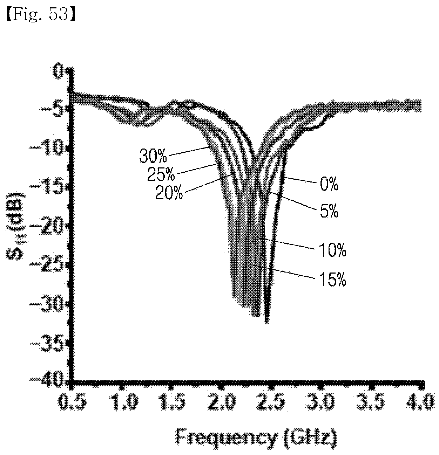

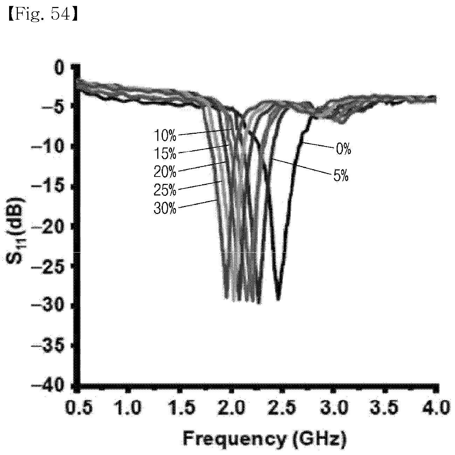

FIG. 52 is a result of measuring frequency characteristics by detuning a resonance frequency when the first composite substrate M-BaTiO$_3$ according to the experimental example of the present invention is stretched in a stretch range of 0.1% to 30%, FIG. 53 is a result of measuring frequency characteristics by detuning a resonance frequency when the second substrate BaTiO$_3$ according to the comparative example is stretched in a stretch range of 0.1% to 30%, and FIG. 54 is a result of measuring frequency characteristics by detuning a resonance frequency when the first stretchable polymer Ecoflex according to the comparative example is stretched in a stretch range of 0.1% to 30%.

Referring to FIGS. 49 to 54, unlike other comparative examples, it can be seen that the first composite substrate M-BaTiO$_3$ maintains a constant frequency of 2.5 GHz without a change in frequency even when the first composite substrate M-BaTiO$_3$ is stretched in the stretch range of 0.1% to 30% (see FIG. 52).

Accordingly, according to the experimental example of the present invention, when the composite substrates 100 and M-BaTiO$_3$ are applied to the high-frequency device, the composite substrates 100 and M-BaTiO$_3$ may maintain a constant frequency, and thus excellent frequency characteristics thereof may be proved.

This may be because, as described above, the composite substrates 100 and M-BaTiO$_3$ may include the dielectric cluster 30, and when the composite substrates 100 and M-BaTiO$_3$ are stretched in an elongation direction, the shape of the dielectric cluster 30 may be changed so that the dielectric constant may decrease linearly and rapidly.

While the present invention has been described in connection with the embodiments, it is not to be limited thereto but will be defined by the appended claims. In addition, it is to be understood that those skilled in the art can substitute, change, or modify the embodiments in various forms without departing from the scope and spirit of the present invention.

**Claims**

1. A composite substrate comprising:

   a stretchable polymer matrix formed of a stretchable polymer having elasticity; and
   a dielectric cluster having a predetermined shape, included in the polymer matrix, and formed of dielectric powder having dielectric properties,
   wherein when the composite substrate is stretched,
   the predetermined shape of the dielectric cluster is changed so that a dielectric constant of the composite substrate is varied.

2. The composite substrate of claim 1, wherein when stretching proceeds in an elongation direction, the predetermined shape of the dielectric cluster is changed such that a number of the dielectric powder per unit volume of the stretchable polymer matrix decreases, and
   the dielectric constant decreases linearly.

3. The composite substrate of claim 1, wherein the composite substrate has a variable dielectric constant range in a stretch range of 0.1% to 30%, and
   the variable dielectric constant is in a range of 1.5 to 7.5.

4. The composite substrate of claim 3, wherein the dielectric constant decreases with a gradient in a range of 0.03 to 0.08 in the stretch range of 0.1% to 30%.

5. The composite substrate of claim 1, wherein the composite substrate has a thermal conductivity in a range of 0.1 W/mk to 10 W/mk.

6. The composite substrate of claim 1, wherein the stretchable polymer is a silicon-based material, and
   the silicon-based material includes at least one selected from materials including ecoflex, polydimethylsiloxane (PDMS), and styrene-ethylene-butylene-styrene (SEBS).

7. The composite substrate of claim 1, wherein the dielectric powder is a metal oxide-based material, and
   the metal oxide-based material is at least one selected from metal oxide-based materials including barium titanate, strontium titanate, and aluminum oxide.

8. A method for manufacturing a composite substrate, the method comprising:

dispersing a stretchable polymer having elasticity in a solvent to prepare a source solution;

mixing dielectric powder having dielectric properties with the source solution to prepare a dielectric source;

providing the dielectric powder with a catalyst that causes an attractive force between dielectric powders so as to form a dielectric cluster having a predetermined shape from the dielectric powders; and

curing the dielectric source in which the dielectric cluster is formed to manufacture the composite substrate having the dielectric cluster that is dispersed in a stretchable polymer matrix formed of the stretchable polymer.

9. The method of claim 8, wherein in the forming of the dielectric cluster, the catalyst is provided to the dielectric source by a dripping method, and

the catalyst is water.

10. The method of claim 8, wherein in the preparing of the source solution, the solvent is a polar liquid that is non-miscible with water,

the polar liquid includes dichloromethane,

the stretchable polymer is a silicon-based material, and

the silicon-based material includes at least one selected from materials including ecoflex, polydimethylsiloxane (PDMS), and styrene-ethylene-butylene-styrene (SEBS).

11. A composite substrate comprising:

a stretchable polymer matrix formed of a stretchable polymer having elasticity; and

a dielectric cluster having a predetermined shape, included in the polymer matrix, and formed of dielectric powder having dielectric properties,

wherein when the composite substrate is stretched,

the predetermined shape of the dielectric cluster is changed so that a dielectric constant of the composite substrate is varied,

the composite substrate has a variable dielectric constant range in a stretch range of 0.1% to 30%,

the variable dielectric constant in a range of 1.5 to 7.5, and

the dielectric constant decreases with a gradient in a range of 0.03 to 0.08 in the stretch range of 0.1% to 30%.

【Fig. 1】

【Fig. 2】

```
                          ┌─────────┐
                          │  Start  │
                          └─────────┘
                               │
                               ▼
┌──────────────────────────────────────────────────────┐
│  Dissolving stretchable polymer material having        │  ── S110
│  elasticity in solvent to prepare stretchable solution │
└──────────────────────────────────────────────────────┘
                               │
                               ▼
┌──────────────────────────────────────────────────────┐
│  Mixing dielectric powder having dielectric properties │  ── S120
│  with stretchable solution to prepare dielectric source│
└──────────────────────────────────────────────────────┘
                               │
                               ▼
┌──────────────────────────────────────────────────────┐
│  Providing dielectric source with catalyst that causes │
│  attractive force between dielectric powders so as to  │  ── S130
│  form dielectric cluster from dielectric powder        │
└──────────────────────────────────────────────────────┘
                               │
                               ▼
┌──────────────────────────────────────────────────────┐
│  Curing dielectric source in which dielectric cluster  │
│  is formed to manufacture composite substrate having   │
│  dielectric cluster that is dispersed in stretchable   │  ── S140
│  polymer matrix formed of stretchable polymer          │
└──────────────────────────────────────────────────────┘
                               │
                               ▼
                          ┌─────────┐
                          │   End   │
                          └─────────┘
```

【Fig. 3】

S110

【Fig. 4】

S120

【Fig. 5】

<u>S130</u>

【Fig. 6】

<u>S130</u>

【Fig. 7】

S140

【Fig. 8】

【Fig. 9】

(a)

(b)

(c)

(d)

【Fig. 10】

0 %  30 %

(a)  (b)

【Fig. 11】

(a)

(b)

(c)

【Fig. 12】

(a)

M-BaTiO₃                    1 mm

(b)

DEEC                    200 μm

(c)

DEEC

(d)

【Fig. 13】

0 %                    30 %

(a)                    (b)

【Fig. 14】

(a)

(b)

(c)

【Fig. 15】

(a)

(b)

(c)

【Fig. 16】

(a)

(b)

(c)

(d)

【Fig. 17】

【Fig. 18】

【Fig. 19】

**Von Mises Stress**

0           30

Strain = 30 %

$BaTiO_3$-μP Composite ($V_f$ = 10%)

(a)

Strain = 30 %

DEEC ($V_f$ = 10%)

(b)

【Fig. 20】

Max Principal Strain

0          100

Initial State
(a)

$v_f = 13\%$

$\varepsilon_{app} = 30\%$    Clusters
can deform
(b)

$v_f = 13\%$

$\varepsilon_{app} = 30\%$    Clusters
cannot deform
(c)

【Fig. 21】

【Fig. 22】

$\varepsilon_{app} = 30\%$

(a)

$\varepsilon_{app} = 30\%$

(b)

【Fig. 23】

Electric Field(A.U.)

0    1

(a)

$\varepsilon_{app} = 30\%$

(b)

C=95F
(c)

C=96fF
(d)

C(fF)

Strain(%)
(e)

【Fig. 24】

【Fig. 25】

【Fig. 26】

【Fig. 27】

【Fig. 28】

【Fig. 29】

【Fig. 30】

【Fig. 31】

【Fig. 32】

【Fig. 33】

【Fig. 34】

【Fig. 35】

【Fig. 36】

【Fig. 37】

【Fig. 38】

【Fig. 39】

【Fig. 40】

【Fig. 41】

【Fig. 42】

【Fig. 43】

(a)

(b)

【Fig. 44】

【Fig. 45】

【Fig. 46】

【Fig. 47】

(a)

(b)

(c)

【Fig. 48】

【Fig. 49】

【Fig. 50】

【Fig. 51】

【Fig. 52】

【Fig. 53】

【Fig. 54】

## INTERNATIONAL SEARCH REPORT

| International application No. |
| --- |
| **PCT/KR2023/019709** |

| A. | CLASSIFICATION OF SUBJECT MATTER |
| --- | --- |

**H05K 1/02**(2006.01)i; **H05K 1/03**(2006.01)i

According to International Patent Classification (IPC) or to both national classification and IPC

| B. | FIELDS SEARCHED |
| --- | --- |

Minimum documentation searched (classification system followed by classification symbols)

H05K 1/02(2006.01); B32B 25/08(2006.01); C25D 11/02(2006.01); C25D 13/02(2006.01); H01B 17/60(2006.01); H01B 3/00(2006.01); H01B 3/28(2006.01); H01G 4/33(2006.01); H01L 41/193(2006.01); H05K 1/05(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 신축성(stretch), 고분자(polymer), 매트릭스(matrix), 유전 클러스터(dielectric cluster), 유전율(permittivity)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 2012-248340 A (BANDO CHEM IND., LTD.) 13 December 2012 (2012-12-13)<br>See paragraphs [0009]-[0055]. | 1,3,5-7 |
| A | | 2,4,8-11 |
| Y | KR 10-2010-0119818 A (TOKYO UNIVERSITY OF SCIENCE EDUCATIONAL FOUNDATION ADMINISTRATIVE ORGANIZATION et al.) 10 November 2010 (2010-11-10)<br>See claims 1-2. | 1,3,5-7 |
| Y | KR 10-2016-0107160 A (CAMBRIDGE NANOTHERM LIMITED) 13 September 2016 (2016-09-13)<br>See paragraph [0064]. | 5 |
| A | JP 2007-083613 A (NTN CORP.) 05 April 2007 (2007-04-05)<br>See paragraphs [0009]-[0020] and claims 1-5. | 1-11 |

[✓] Further documents are listed in the continuation of Box C.　　[✓] See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **12 March 2024** | **12 March 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2023/019709** |

### C.    DOCUMENTS CONSIDERED TO BE RELEVANT

| Category* | Citation of document, with indication, where appropriate, of the relevant passages | Relevant to claim No. |
| --- | --- | --- |
| A | EP 3373349 A1 (KONINKLIJKE PHILIPS N.V.) 12 September 2018 (2018-09-12) See paragraph [0078], claim 1 and figure 4. | 1-11 |

## INTERNATIONAL SEARCH REPORT
### Information on patent family members

International application No.

**PCT/KR2023/019709**

| Patent document cited in search report | | | Publication date (day/month/year) | Patent family member(s) | | | Publication date (day/month/year) |
|---|---|---|---|---|---|---|---|
| JP | 2012-248340 | A | 13 December 2012 | | None | | |
| KR | 10-2010-0119818 | A | 10 November 2010 | CN | 101981236 | A | 23 February 2011 |
| | | | | JP | 2011-119358 | A1 | 21 July 2011 |
| | | | | JP | 5373767 | B2 | 18 December 2013 |
| | | | | JP | WO2009-119358 | A1 | 21 July 2011 |
| | | | | TW | 200949872 | A | 01 December 2009 |
| | | | | US | 2011-0013342 | A1 | 20 January 2011 |
| | | | | WO | 2009-119358 | A1 | 01 October 2009 |
| KR | 10-2016-0107160 | A | 13 September 2016 | CN | 105706231 | A | 22 June 2016 |
| | | | | CN | 106029955 | A | 12 October 2016 |
| | | | | CN | 106029955 | B | 09 January 2018 |
| | | | | CN | 106134302 | A | 16 November 2016 |
| | | | | EP | 3061128 | A1 | 31 August 2016 |
| | | | | EP | 3068927 | A1 | 21 September 2016 |
| | | | | EP | 3069583 | A1 | 21 September 2016 |
| | | | | JP | 2016-538425 | A | 08 December 2016 |
| | | | | JP | 2016-538725 | A | 08 December 2016 |
| | | | | JP | 2017-500730 | A | 05 January 2017 |
| | | | | KR | 10-2016-0074661 | A | 28 June 2016 |
| | | | | KR | 10-2016-0121506 | A | 19 October 2016 |
| | | | | TW | 201517335 | A | 01 May 2015 |
| | | | | US | 10299374 | B2 | 21 May 2019 |
| | | | | US | 2015-0118391 | A1 | 30 April 2015 |
| | | | | US | 2016-0286644 | A1 | 29 September 2016 |
| | | | | US | 2016-0302300 | A1 | 13 October 2016 |
| | | | | WO | 2015-061649 | A1 | 30 April 2015 |
| | | | | WO | 2015-071635 | A1 | 21 May 2015 |
| | | | | WO | 2015-071636 | A1 | 21 May 2015 |
| | | | | WO | 2015-071636 | A8 | 06 August 2015 |
| JP | 2007-083613 | A | 05 April 2007 | JP | 4667185 | B2 | 06 April 2011 |
| EP | 3373349 | A1 | 12 September 2018 | WO | 2018-162333 | A1 | 13 September 2018 |

Form PCT/ISA/210 (patent family annex) (July 2022)

**EP 4 629 752 A1**

**Patent documents cited in the description**

- KR 1020100011023
- KR 1020170017612